# EUROPEAN PATENT APPLICATION

(11) **EP 1 699 088 A1**
(43) Date of publication of application: **06.09.2006**
(21) Application number: 04734132.6
(22) Date of filing: 20.05.2004
(51) Int. Cl.: H01L 29/872

(54) **RECTIFYING DEVICE AND ELECTRONIC CIRCUIT EMPLOYING SAME, AND PROCESS FOR PRODUCING RECTIFYING DEVICE**

(30) Priority: 26.12.2003 JP 2003435577
(71) Applicant: FUJI XEROX CO., LTD., Minato-ku, Tokyo, 107-0052 (JP)
(72) Inventor: OKADA, Shinsuke, c/o Fuji Xerox Co., Ltd.,, Kanagawa, 2590157 (JP); HIRAKATA, Masaki, c/o Fuji Xerox Co., Ltd.,, Kanagawa, 2590157 (JP); MANABE, Chikara, c/o Fuji Xerox Co., Ltd.,, Kanagawa, 2590157 (JP); ANAZAWE, Kazunori, c/o Fuji Xerox Co., Ltd.,, Kanagawa, 2590157 (JP); OKADA, Shinsuke, Saitama 332-0023 (JP); WATANABE, Miho, c/o Fuji Xerox Co., Ltd.,, Kanagawa, 2590157 (JP); KISHI, Kentari, c/o Fuji Xerox Co., Ltd.,, Kanagawa, 2590157 (JP); ISOZAKI, S., c/o Fuji Xerox Co., Ltd.,, Kanagawa, 2590157 (JP); GOMA, Shigeki, c/o Fuji Xerox Co., Ltd.,, Kanagawa, 2590157 (JP); WATANABE, Shiyoku, c/o Fuji Xerox Co., Ltd.,, Kanagawa, 2590157 (JP)
(74) Representative: Forstmeyer, Dietmar
(86) International application number: PCT/JP2004/007201
(87) International publication number: WO 2005/067059

(57) **Abstract**

To provide a rectifying device equipped with a carrier transporter excellent in high frequency responsiveness and heat resistance, an electronic circuit using the same, and a method of manufacturing the rectifying device. The rectifying device includes a pair of electrodes, and a carrier transporter arranged between the pair of electrodes and composed of one or multiple carbon nanotubes. In order that a first interface between one electrode of the pair of electrodes and the carrier transporter and a second interface between the other electrode of the pair of electrodes and the carrier transporter may have different barrier levels, connection configuration of them are made different.

## Description

### TECHNICAL FIELD

The present invention relates to a rectifying device using a carbon nanotube structure as a carrier transporter, an electronic circuit using the same, and a method of manufacturing a rectifying device.

### BACKGROUND ART

Carbon nanotubes (CNTs), with their unique shapes and characteristics, may find various applications. A carbon nanotube has a tubular shape of one-dimensional nature which is obtained by rolling one or more graphene sheets composed of six-membered rings of carbon atoms into a tube. A carbon nanotube formed from one graphene sheet is called a single-wall carbon nanotube (SWNT) while a carbon nanotube formed from multiple graphene sheets is called a multi-wall carbon nanotube (MWNT). SWNTs are about 1 nm in diameter whereas multi-wall carbon nanotubes are several tens nm in diameter, and both are far thinner than their predecessors, which are called carbon fibers.

One of the characteristics of carbon nanotubes resides in that the aspect ratio of length to diameter is very large since the length of carbon nanotubes is on the order of micrometers. Carbon nanotubes are unique in their extremely rare nature of being both metallic and semiconductive because six-membered rings of carbon atoms in carbon nanotubes are arranged into a spiral. In addition, the electrical conductivity of carbon nanotubes is very high and allows a current flow at a current density of 100 MA/cm² or more.

Carbon nanotubes excel not only in electrical characteristics but also in mechanical characteristics. That is, the carbon nanotubes are distinctively tough, as attested by their Young's moduli exceeding 1 TPa, which belies their extreme lightness resulting from being formed solely of carbon atoms. In addition, the carbon nanotubes have high elasticity and resiliency resulting from their cage structure. Having such various and excellent characteristics, carbon nanotubes are very appealing as industrial materials.

Applied researches that exploit the excellent characteristics of carbon nanotubes have been heretofore made extensively. To give a few examples, a carbon nanotube is added as a resin reinforcer or as a conductive composite material while another research uses a carbon nanotube as a probe of a scanning probe microscope. Carbon nanotubes have also been used as minute electron sources, electric field emission rectifying devices, and flat displays. An application that is being developed is to use a carbon nanotube as a hydrogen storage.

As described above, carbon nanotubes are expected to find use in various applications, and their application as electronic materials and electronic devices has been attracting attention. Electronic devices such as a diode and a transistor have already been prototyped by using carbon nanotubes, and are expected to replace the existing silicon semiconductors.

In recent years, electronic devices have been requested to find use in a wider region. For example, an increase in efficiency and energy savings are indispensable to applications such as energy conversion to cope with environmental problems. In addition, electronic devices are often requested to operate stably in various environments such as high temperature environment.

Such requests are satisfied in terms of two aspects: a device material and a device structure. However, at present, the structure of a device using silicon that is currently going mainstream can satisfy the requirements only in a limited range owing to the limitations on silicon as a material. The use of a semiconductor material such as gallium arsenide is not desirable from the viewpoint of load to the environment. Therefore, an electronic device using a semiconductor material replacing the existing materials has been demanded.

A rectifying device, which is the most basic out of various electronic devices, is capable of allowing an electric current to flow only in one direction of the device. The rectifying device is requested to have high output, high speed, high frequency, and low loss in order to satisfy the above requirements. The utilization of a member superior to silicon in properties such as a high breakdown electric field strength, a saturated drift velocity, and a thermal conductivity has been vigorously examined in order to realize such rectifying device.

There exist two documents that have reported diodes using carbon nanotubes: Hu, J. Ouyang, M. Yang, P. Lieber, C. M. Nature, 399, 48-51 (1999) and Yao, Z. Postma, H. W. C. Balents, L. Dekker, C. Nature, 402, 273-276 (1999). In the former document, hetero bonding between a carbon nanotube and a silicon nanowire is formed to express rectifying action. In the latter document, a carbon nanotube is bent and arranged by means of a manipulate method to express rectifying action.

However, the number of reported rectifying devices using carbon nanotubes is not very large, and the number of production examples of devices each of which has a controlled rectifying direction is smaller.

Carbon nanotubes are expected to find use in carrier transporters of rectifying devices capable of operating at high frequency or high temperature because of the properties of the carbon nanotubes including quick response and a high thermal conductivity. In addition, the rectifying devices can be reduced in size and implemented at high density because of the small sizes of the carbon nanotubes. Furthermore, attention should be paid to the fact that the carbon nanotubes apply a small load to the environment because they are composed only of carbon. However, the existing rectifying devices using carbon nanotubes as carrier transporters are not suitable for practical use because their rectifying directions cannot be controlled.

### DISCLOSURE OF THE INVENTION

Therefore, an object of the present invention is to solve the above problems. More specifically, an object of the present invention is to provide: a rectifying device capable of effectively using the properties of a carbon nanotube structure, an electronic circuit using the same, and a method of manufacturing a rectifying device.

The above obj ect is achieved by the present invention described below.

That is, according to one aspect of the present invention, there is provided a rectifying device, including a pair of electrodes, and a carrier transporter arranged between the pair of electrodes and composed of one or multiple carbon nanotubes, characterized in that a first connection configuration between one electrode of the pair of electrodes and the carrier transporter and a second connection configuration between the other electrode of the pair of electrodes and the carrier transporter are made different from each other in such a manner that a first interface between the one electrode and the carrier transporter and a second interface between the other electrode and the carrier transporter have different barrier levels.

In the rectifying device of the present invention, the first interface and the second interface have different barrier levels. Accordingly, at least one of the first interface and the second interface does not provide a so-called ohmic connection in which an electron and a hole alternately go and come in a thermal equilibrium state in no electric field. Representative examples of connection configurations except the ohmic connection include a metal-insulator-semiconductor (MIS) barrier andaSchottky barrier.

The term "barrier level" refers to the ease with which a carrier (an electron or a hole) transits at an interface between a carrier transporter and an electrode in no electric field and in thermal equilibrium, or the size of the energy barrier. The barrier level becomes asymmetric at the first interface and second interface of the carrier transporter, whereby rectifying action occurs at the time of application of a voltage.

The carrier transporter in the present invention is an object in which electrical conduction occurs as a result of the propagation of carriers (an electron and a hole) in a medium, unlike a metal in which a free electron propagates. When a carrier transporter is composed of a carbon nanotube as in the case of the present invention, the carrier transporter exhibits semiconductor properties in not only the case where the carbon nanotube is of a semiconductor type but also the following cases. For example, multiple carbon nanotubes each having metallic properties constitute a carbon nanotube structure via cross-linked sites as described separately, whereby the carrier transporter entirely exhibits semiconductor properties. Alternatively, the entanglement of or contact between carbon nanotubes in a carbon nanotube dispersion film causes the carrier transporter to exhibit semiconductor properties.

The carrier transporter in the present invention is preferably composed of multiple carbon nanotubes. When the carrier transporter is composed of one carbon nanotube, the maximum current that can flow is small. However, the use of multiple carbon nanotubes can increase the maximum current. In addition, a carrier transporter composed of multiple carbon nanotubes is superior in safety to that composed of one carbon nanotube because an electrical network in the carrier transporter is surely formed.

The carrier transporter in the present invention is more preferably composed of a carbon nanotube structure having a network structure in which multiple carbon nanotubes mutually cross-link. The use of a carbon nanotube structure in which multiple carbon nanotubes constitute a network structure via multiple cross-linked sites as a carrier transporter can provide a stable rectifying device. The reason for this is as follows. Unlike the case where a mere carbon nanotube dispersion film is used as a carrier transporter, the connection state of a carrier transporter does not fluctuate and rectifying properties do not become unstable even when the state of contact between carbon nanotubes and the state of arrangement of the carbon nanotubes, and the environment where the carrier transporter is used become unstable.

Such carrier transporter as described above is preferable also in that a rectifying device can be constituted by using readily available multi-wall carbon nanotubes because the presence of cross-linked sites provides semiconductor properties.

In the rectifying device of the present invention, an oxide layer is particularly preferably allowed to be present on at least one of the first interface and the second interface to make the first and second connection configurations different from each other in such a manner that the first interface and the second interface have different barrier levels. The presence of an oxide allows a high energy barrier to be formed, and prevents the traffic of carriers at an interface in no electric field to an increased extent. One of the electrodes of the rectifying device having the configuration becomes an anode and the other becomes a cathode. When the carrier transporter is of a p type, an electrode in contact with an oxide film having a higher barrier level becomes a cathode. When the carrier transporter is of an n type, an electrode having a larger barrier becomes an anode. Each of the carbon nanotubes composing the carrier transporter can be made a p type or an n type according to, for example, how doping is performed, so each of the electrodes can be set to a cathode as required.

The oxide layer is preferably a metal oxide film (including an oxide film of an alloy) or an oxide film of a semiconductor, and is not necessarily made of uniform oxide films having the same composition. The oxide layer may be composed by, for example, juxtaposing or laminating multiple kinds of oxide films. The oxide layer is preferably composed of at least one selected from the group consisting of aluminum oxide, silicon dioxide, copper oxide, silver oxide, titanium oxide, zinc oxide, tin oxide, nickel oxide, magnesium oxide, indium oxide, chromium oxide, lead oxide, manganese oxide, iron oxide, palladium oxide, tantalum oxide, tungsten oxide, molybdenum oxide, vanadium oxide, cobalt oxide, hafnium oxide, and lanthanum oxide.

An oxide layer is particularly preferably inserted into the first interface between the surface of the carrier transporter and the one electrode (which may hereinafter be referred to as "a first electrode"). A layer such as a conductive layer made of a material different from that of the first electrode may be interposed between the oxide layer and the first electrode to the extent that a function of the rectifying device is not impaired.

On the other hand, the second interface between the surface of the carrier transporter and the other electrode (which may hereinafter be referred to as "a second electrode") may be directly ohmic-connected, or a layer such as a laminate of multiple materials may be present at the second interface so that the second interface has a barrier level different from that at the first interface to the extent that a function of the rectifying device is not impaired.

In order that one of the barrier levels of the first interface and the second interface may be larger than the other, oxide layers may be formed at both interfaces; provided, however, that the oxide layers are formed in such a manner that they are not brought into a so-called ohmic connection state in which an electron and a hole alternately go and come in a thermal equilibrium state in no electric field.

A material composing the pair of electrodes is preferably at least one metal selected from the group consisting of titanium, aluminum, silver, copper, silicon that is made conductive, iron, tantalum, niobium, gold, platinum, zinc, tungsten, tin, nickel, magnesium, indium, chromium, manganese, lead, palladium, molybdenum, vanadium, cobalt, hafnium, and lanthanum, or an alloy thereof. A material composing one electrode of the pair of electrodes is particularly preferably at least one metal selected from the group consisting of titanium, aluminum, silver, copper, silicon that is made conductive, iron, tantalum, niobium, zinc, tungsten, tin, nickel, magnesium, indium, chromium, palladium, molybdenum, and cobalt, or an alloy thereof.

The materials for the pair of electrodes are not limited to metals or alloys, and may be semiconductors that are made conductive or organic materials, but the pair of electrodes is preferably ohmic-connected to the carrier transporter or the oxide layer. Each of the electrodes may also be formed of a combination of multiple metals such as lamination.

One electrode of the pair of electrodes may be composed of amaterialdifferent fromthatof theotherelectrode. Inparticular, materials for the one electrode and the other electrode may be different in such a manner that the first interface and the second interface have different barrier levels.

The electrode materials are more preferably those capable of forming oxide films (such as aluminum, silver, copper, silicon that is made conductive, titanium, zinc, nickel, tin, magnesium, indium, chromium, manganese, iron, lead, palladium, tantalum, tungsten, molybdenum, vanadium, cobalt, hafnium, and lanthanum). The reason for this is as follows. When the surface of an electrode is oxidized to form an oxide layer, the oxide layer can be present in a state where a portion serving as an electrode not oxidized and the carrier transporter are sufficiently close to each other as compared to the case where an oxide layer is separately allowed to be present. As a result, a carrier can move with increased ease, and the rectifying device can be easily driven at a low voltage. The materials are preferably those capable of forming oxide layers also in terms of productivity and the ability to stably form oxide layers with appropriate thicknesses.

The ease of oxidation is represented by the ionization tendency of each material. For example, the following materials are arranged in order of decreasing ease of oxidation.

Li, K, Ca, Na, Mg, Al, Ti, Mn, Si, Zn, Cr, Fe (II), Cd, Co, Ni, In, Sn, Pb, Fe (iii), (H), Cu, Hg, Ag, Pd, Pt, Au

The ionization tendency of a conductive material composing one electrode is extremely preferably higher than a material composing the other electrode. This is because a connection configuration in which a difference in amount of an oxide layer to be formed occurs to generate a difference in barrier level can be easily attained, so a stable barrier can be formed.

When a carrier transporter composed of multiple carbon nanotubes is used, oxidative materials are placed in advance so as to be adjacent to the carbon nanotubes, and the materials are oxidized to form oxide layers, the carrier transporter has a network structure, so oxygen can be supplied via the network structure to the surfaces of the oxidative materials, and the oxide layers can be certainly formed.

In a preferred embodiment of the rectifying device of the present invention, a material for the one electrode and a material for the other electrode are made different in such a manner that the first interface and the second interface have different barrier levels. When the material for the first electrode and the material for the second electrode are made different, the first interface and the second interface can stably obtain different barrier levels according to material physical properties at an interface between an electrode and a carrier transporter or the like.

At this time, the materials composing the one electrode and the other electrode preferably each independently are at least one metal selected from the group consisting of aluminum, silver, copper, silicon that is made conductive, gold, platinum, titanium, zinc, nickel, tin, magnesium, indium, chromium, manganese, iron, lead, palladium, tantalum, tungsten, molybdenum, vanadium, cobalt, hafnium, and lanthanum, or an alloy thereof, and the material composing the one electrode and the material composing the other electrode are preferably made different.

At this time, the material composing the other electrode is preferably at least one metal selected from the group consisting of gold, titanium, iron, nickel, tungsten, silicon that is made conductive, chromium, niobium, cobalt, molybdenum, and vanadium, or an alloy thereof.

Alternatively, a degree of adhesion between the one electrode and the carrier transporter at the first interface is also preferably smaller than a degree of adhesion between the other electrode and the carrier transporter at the second interface. The degree of adhesion between a carbon nanotube and an electrode, which varies depending on an electrode material to be used, can make a barrier level different owing to a difference in material physical properties.

Here, the term "degree of adhesion" refers to a difference in adhesion performance between an electrode material and a carbon nanotube composing a carrier transporter. For example, when two metallic thin films are superimposed, the layers closely adhere to provide a multi-layer structure if the layers are each made of a material having a high degree of adhesion. However, if the layers are each made of a material having a poor degree of adhesion, they cannot provide a layer structure, or, even when they provide a multi-layer structure, a gap is formed between layers. Since a carbon nanotube is not a film but a tubular structure, the term refers to a degree of adhesion between the surface of the nanotube and an electrode material when an electrode is deposited on the nanotube.

Alternatively, when the surface of a portion of a carbon nanotube to impinge on the first interface is modified through ion beam irradiation, an oxidation treatment, or the like, an efficiency of adhesion with an electrode material can be reduced or increased, and a degree of adhesion can be reduced or increased. As a result, a barrier level can be further increased. At this time, when an oxidative material is used for an electrode, the surface of the electrode at the first interface is more easily or more hardly oxidized even when the entirety is oxidized because the degree of adhesion with the carrier transporter is reduced or increased. As a result, different barriers are formed at the first and second interfaces. A desired barrier level can be formed more freely by appropriately combining the selection of an electrode material and the surface treatment of a carbon nanotube described above.

In one preferred mode of the rectifying device of the present invention, an adhesion force adjusting layer is particularly preferably allowed to be present on at least one of the first interface and the second interface to generate a difference between the degree of adhesion between the one electrode and the carrier transporter at the first interface and the degree of adhesion between the other electrode and the carrier transporter at the second interface.

For example, when an aminosilane, thiol, polymer (resist, polycarbonate, PMMA), SAM, LB film, or the like is allowed to adhere to an interface, and then an electrode is formed by deposition or the like, the degree of adhesion between the interface and the electrode can be controlled. A barrier level can be made different depending on a difference in degree of adhesion.

The carbon nanotube structure is preferably obtained by chemically bonding functional groups bonded to multiple carbon nanotubes to form cross-linked sites. The cross-linked sites can be formed by, for example, chemically bonding functional groups bonded to multiple carbon nanotubes in a solution.

The multiple carbon nanotubes may be single-wall carbon nanotubes or multi-wall carbon nanotubes. When the multiple carbon nanotubes are mainly composed of single-wall carbon nanotubes, a carbon nanotube structure can be formed at high density, so a reduction in performance of a carrier transporter is small even when microprocessing such as patterning is performed. On the other hand, when the carbon nanotubes are mainly composed of multi-wall carbon nanotubes, the allowable maximum current of a multi-wall carbon nanotube as a conductor is larger than that of a single-wall carbon nanotube, so applications as a rectifier can be expanded. Furthermore, a multi-wall carbon nanotube is hardly bundled as compared to a single-wall carbon nanotube, so it is excellent in uniformity of physical properties. A multi-wall carbon nanotube is preferable also in terms of production because it can be produced at low cost and can be easily handled.

The term "mainly" as used herein means "dominant" or the like, and refers to a ratio of single-wall or multi-wall carbon nanotubes to all carbon nanotubes. It is more preferable that single-wall (or multi-wall) carbon nanotubes account for 90% or more of all carbon nanotubes to provide the merit of a single-wall (or multi-wall) carbon nanotube. The same holds true for the subsequent interpretation of "mainly".

The carbon nanotube structure may be formed in a state where single-walland multi-wallcarbon nanotubesare mixed. Inthiscase, the properties of both the single-wall and multi-wall carbon nanotubes can be utilized. In this case, a first structure mainly composed of multi-wall carbon nanotubes is preferably combined mainly with single-wall carbon nanotubes to provide a composite structure.

Of those, a first structure preferable as the cross-linked site is a structure formed by using and curing a solution containing carbon nanotubes to which functional groups are bonded and a cross-linking agent capable of prompting a cross-linking reaction with the functional groups to subject the functional groups and the cross-linking agent to a cross-linking reaction. The cross-linking agent is more preferably non-self-polymerizable.

By forming the carbon nanotube structure through the above curing of the solution, the cross-linked site where the carbon nanotubes are cross-linked together can have a cross-linking structure in which residues of the functional groups remaining after a cross-linking reaction are connected together using a connecting group which is a residue of the cross-linking agent remaining after the cross-linking reaction.

If the cross-linking agent has property of polymerizing with other cross-linking agents (self-polymerizability), the connecting group may contain a polymer in which two or more cross-linking agents are connected, thereby reducing an actual density of the carbon nanotubes in the carbon nanotube structure. Therefore, a rectifying device to be obtained will have a small current value in forward bias and provide a small rectification ratio.

On the other hand, a non-self-polymerizable cross-linking agent allows control of a gap between each of the carbon nanotubes to a size of a cross-linking agent residue used. Therefore, a desired network structure of carbon nanotubes can be obtained with high duplicability. Further, reducing the size of the cross-linking agent residue can extremely narrow a gap between the carbon nanotubes electrically and physically. In addition, carbon nanotubes in the structure can be densely structured. As a result, a large forward current is obtained, and hence a large rectification ratio is obtained.

Therefore, a non-self-polymerizable cross-linking agent can provide the carbon nanotube structure according to the present invention exhibiting the electrical characteristics and mechanical characteristics of a carbon nanotube itself at high levels.

In the present invention, the term"self-polymerizable" refers to property with which the cross-linking agents may prompt a polymerization reaction with each other in the presence of other components such as water or in the absence of other components. On the other hand, the term "non-self-polymerizable" means that the cross-linking agent has no such property.

A selection of a non-self-polymerizable cross-linking agent as the cross-linking agent provides a cross-linked site, where carbon nanotubes in a coat of the present invention are cross-linked together, having primarily an identical cross-linking structure. Furthermore, the connecting group preferably has hydrocarbon as its skeleton, and the hydrocarbon preferably has 2 to 10 carbon atoms. Reducing the number of carbon atoms can shorten the length of a cross-linked site and sufficiently narrow a gap between carbon nanotubes as compared to the length of a carbon nanotube itself. As a result, a carbon nanotube structure having a network structure composed substantially only of carbon nanotubes can be obtained. A carrier transporter thus obtained can surely form a carrier transportation path even if it is patterned into a fine size because of its high density.

Examples of the functional group include -OH, -COOH, -COOR (where R represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of which may be substituted), -COX (where X represents a halogen atom), -NH₂, and -NCO. A selection of at least one functional group from the group consisting of the above functional groups is preferable, and in such a case, a cross-linking agent, which may prompt a cross-linking reaction with the selected functional group, is selected as the cross-linking agent.

Further, examples of the preferable cross-linking agent include a polyol, a polyamine, a polycarboxylic acid, a

polycarboxylate, a polycarboxylic acid halide, a polycarbodiimide, and a polyisocyanate. A selection of at least one cross-linking agent from the group consisting of the above cross-linking agents is preferable, and in such a case, a functional group, which may prompt a cross-linking reaction with the selected cross-linking agent, is selected as the functional group.

At least one functional group and at least one cross-linking agent are preferably selected respectively from the group consisting of the functional groups exemplified as the preferable functional groups and the group consisting of the cross-linking agents exemplified as the preferable cross-linking agents, so that a combination of the functional group and the cross-linking agent may prompt a cross-linking reaction with each other.

Examples of the particularly preferable functional group include -COOR (where R represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of which may be substituted). Introduction of a carboxyl group into carbon nanotubes is relatively easy, and the resultant substance (carbon nanotube carboxylic acid) has high reactivity. Therefore, after the formation of the substance, it is relatively easy to esterify the substance to convert its functional group into -COOR (where R represents the same as that described above). The functional group easily prompts a cross-linking reaction and is suitable for formation of a coat.

A polyol can be exemplified as the cross-linking agent corresponding to the functional group. A polyol is cured by a reaction with -COOR (where R represents the same as that described above), and forms a robust cross-linked substance with ease. Out of polyols, each of glycerin and ethylene glycol reacts with the above functional groups well. Moreover, each of glycerin and ethylene glycol itself is highly biodegradable, and provides a low environmental load.

In the cross-linked site where multiple carbon nanotubes mutually cross-link, the functional group is -COOR (where R represents a substituted or unsubstituted hydrocarbon group). The cross-linked site is -COO(CH₂)₂OCO- in the case where ethylene glycol is used as the cross-linking agent. In the case where glycerin is used as the cross-linking agent, the cross-linked site is -COOCH₂CHOHCH₂OCO- or -COOCH₂CH(OCO-)CH₂OH if two OH groups contribute to the cross-linking, and the cross-linked site is -COOCH₂CH(OCO-)CH₂OCO- if three OH groups contribute to the cross-linking. The chemical structure of the cross-linked site may be any chemical structure selected from the group consisting of the above four structures.

A second structure preferable as the structure of the cross-linked site of carbon nanotubes is a structure formed through chemical bonding of multiple functional groups together. More preferably, a reaction that forms the chemical bonding is any one of dehydration condensation, a substitution reaction, an addition reaction, and an oxidative reaction.

The carbon nanotube structure of this case forms a cross-linked site by chemically bonding together functional groups bonded to the carbon nanotubes, to thereby form a network structure. Therefore, the size of the cross-linked site for bonding the carbon nanotubes together becomes constant depending on the functional group to be bonded. Since a carbon nanotube has an extremely stable chemical structure, there is a low possibility that functional groups or the like other than a functional group to modify the carbon nanotube are bonded to the carbon nanotube. In the case where the functional groups are chemically bonded together, the designed structure of the cross-linked site can be obtained, thereby providing a homogeneous carbon nanotube structure.

Furthermore, the functional groups are chemically bonded together, so that the length of the cross-linked site between the carbon nanotubes can be shorter than that in the case where the functional groups are cross-linked together with a cross-linking agent. Therefore, the carbon nanotube structure is dense, and an effect peculiar to a carbon nanotube is easily provided.

In addition, multiple carbon nanotubes construct a network structure through multiple cross-linked sites in the carbon nanotube structure of the present invention. As a result, excellent characteristics of a carbon nanotube can be stably used unlike a material such as a mere carbon nanotube dispersion film or resin dispersion film in which carbon nanotubes are only accidentally in contact with each other and are substantially isolated from each other.

The chemical bonding of the multiple functional groups together is preferably one selected from -COOCO-, -O-, -NHCO-, -COO-, and -NCH- in a condensation reaction. The chemical bonding is preferably at least one selected from -NH-, -S-, and -O- in a substitution reaction. The chemical bonding is preferably -NHCOO- in an addition reaction. The chemical bonding is preferably -S-S- in an oxidative reaction.

Examples of the functional group to be bonded to a carbon nanotube prior to the reaction include -OH, -COOH, -COOR (where R represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of which may be substituted), -X, -COX (where X represents a halogen atom), -SH, -CHO, -OSO₂CH₃, -OSO₂(C₆H₄)CH₃, -NH₂, and -NCO. It is preferable to select at least one functional group from the group consisting of the above functional groups.

Particularly preferable examples of the functional group include-COOH. A carboxyl group can be relatively easily introduced into a carbon nanotube. In addition, the resultant substance (carbon nanotube carboxylic acid) has high reactivity, easily prompts a condensation reaction by using a dehydration condensation agent such as N-ethyl-N'-(3-dimethylaminopropyl)carbodiimide, and thus is suitable for forming a coat.

When the carrier transporter is of a layer shape, and the carbon nanotube structure is patterned into a predetermined shape, a fine rectifying device can be obtained. When a carbon nanotube having a carbon nanotube structure chemically bonded together at cross-linked sites is patterned to form a carrier transporter, even a fine-size carbon nanotube structure is densely formed, so a carrier conduction path is surely secured, and the resultant carbon nanotube structure can be suitably used as a carrier transporter.

When a carrier transporter composed of multiple carbon nanotubes is used, a barrier level at a first interface is preferably higher than a barrier level at a second interface, and the width of the surface of one electrode is preferably equal to or greater than the width of the carrier transporter at an interface between the one electrode and the carrier transporter. At this time, a first connection configuration preferably contains an oxide layer at the first interface. The term "width" as used herein refers to a direction perpendicular to the direction of an electric field between a pair of electrodes.

When the width of the carrier transporter is set to be equal to or smaller than the width of an electrode having a higher barrier level, a carrier cannot help passing through a barrier, so on-off properties are improved. When the width of the one electrode is smaller than the width of the carrier transporter, sufficient rectifying action may not be obtained because a current escapes to a portion free of barrier or having a low barrier at the side of the electrode (portion not on the side to which the pair of electrodes is opposed).

In this mode (in which the width of the one electrode is equal to or greater than the width of the carrier transporter), an oxide layer having such configuration as described above may be present at the first interface.

In addition, the rectifying device of the present invention preferably includes a sealing member for sealing at least the first interface against external air. That is, the first interface is preferably sealed with a resin or the like for preventing changes in properties as a result of the progress of the oxidation of a carbon nanotube itself, or an oxide layer, due to oxygen supplied from the external air in the environment where the device is used. As long as at least the first interface is sealed, a change of an oxide layer, for example, present at the interface, if any, can be prevented. The entire carbon nanotube structure is preferably sealed to prevent the deterioration of transport properties of a carbon nanotube as a carrier transporter due to external air.

### (Electronic Circuit)

The electronic circuit of the present invention is characterized by including: the rectifying device of the present invention as described above; and a flexible base body having the rectifying device formed on its surface. The rectifying device of the present invention has high resistance to bending or the like because it is composed of a carbon nanotube. Accordingly, the formation of the rectifying device on the surface of a flexible base body results in an electronic circuit having high resistance. At this time, a carbon nanotube structure having carbon nanotubes chemically bonded together at cross-linked sites is more preferably patterned to form a carrier transporter because the deterioration of transport properties as a result of a fluctuation in bonding between carbon nanotubes in the carrier transporter caused by bending is prevented.

### (Manufacturing Method)

According to another aspect of the present invention, there is provided a method of manufacturing a rectifying device including: a base body; a pair of electrodes arranged on the surface of the base body; and a carrier transporter arranged between the pair of electrodes and composed of one or multiple carbon nanotubes, characterized by including at least a connection configuration forming step of forming a first connection configuration between one electrode of the pair of electrodes and the carrier transporter and a second connection configuration between the other electrode of the pair of electrodes and the carrier transporter into different configurations in such a manner that a first interface between the one electrode and the carrier transporter and a second interface between the other electrode and the carrier transporter have different barrier levels.

According to the method of manufacturing a rectifying device of the present invention (which may hereinafter be simply referred to as "the manufacturing method of the present invention"), a rectifying device having desired properties can be manufactured by means of a carrier transporter composed of a carbon nanotube easily as compared to a conventional approach.

That is, the manufacturing method of the present invention includes a connection configuration forming step of forming a first connection configuration between one electrode of the pair of electrodes and the carrier transporter and a second connection configuration between the other electrode of the pair of electrodes and the carrier transporter into different configurations in such a manner that a first interface between the one electrode and the carrier transporter and a second interface between the other electrode and the carrier transporter have different barrier levels. As a result, a rectifying device with its rectifying direction controlled can be certainly manufactured.

The connection configuration forming step in the present invention particularly preferably includes an oxide layer forming step of forming, at the first interface between the one electrode and the carrier transporter, an oxide layer such that the first interface has a barrier level different from that of the second interface between the other electrode and the carrier transporter. The oxide layer can easily form different barrier levels because it can form a high energy barrier at the interface with the carrier transporter and has a stable structure owing to oxidation. To be specific, the oxide layer can be formed by directly depositing an oxide or by oxidizing a material not oxidized yet to be described later.

The oxide layer forming step is more preferably a step including: arranging an oxide precursor layer composed of a material that can be oxidized at the first interface; and oxidizing the oxide precursor layer. When the oxide precursor layer composed of a material not oxidized yet is arranged at the first interface before the layer is oxidized, the thickness of an oxide film can be made uniform and thin by virtue of an oxidative atmosphere. Accordingly, as compared to the case where an oxide layer is separately formed, fluctuations in properties are small and productivity is increased.

At this time, the carrier transporter is more preferably formed by a carbon nanotube structure having a network structure in which multiple carbon nanotubes mutually cross-link, and the oxide layer forming step is more preferably a step including: forming the oxide precursor layer so as to be in contact with the carrier transporter; and oxidizing the oxide precursor layer. In this case, oxygen is supplied to the oxide precursor layer through the network structure, whereby the oxide layer can be uniformly formed.

The oxide layer forming step is preferably a step including: forming one electrode of the pair of electrodes from a material that can be oxidized; and oxidizing the surface of the one electrode at the first interface to form an oxide layer. At this time, the carrier transporter is more preferably formed by a carbon nanotube structure having a network structure in which multiple carbon nanotubes mutually cross-link, and the oxide layer forming step is more preferably a step including: forming the one electrode so as to be in contact with the carrier transporter; and oxidizing the one electrode at a surface where the electrode and the carrier transporter are in contact with each other. In the case where the carrier transporter is composed of a network structure formed by multiple carbon nanotubes, when the one electrode formed of an oxidative electrode material is formed on the surface of the carrier transporter, and then the surface of the one electrode is oxidized to form an oxide layer, the surface of the electrode can be efficiently and widely oxidized by oxygen to be supplied through the network structure. Accordingly, a barrier level can be controlled with improved accuracy by, for example, adjusting an oxidation region or an oxidation time.

At this time, the material composing the one electrode of the pair of electrodes is preferably at least one metal selected from the group consisting of aluminum, silver, copper, silicon that is made conductive, titanium, zinc, nickel, tin, magnesium, indium, chromium, manganese, iron, lead, palladium, tantalum, tungsten, molybdenum, vanadium, cobalt, hafnium, and lanthanum, or an alloy thereof.

At this time, the material composing the other electrode is preferably at least one metal selected from the group consisting of gold, titanium, iron, nickel, tungsten, silicon that is made conductive, chromium, niobium, cobalt, molybdenum, and vanadium, or an alloy thereof.

In the case where an oxide layer is formed at the first interface, when the other electrode is composed of a material having a lower ionization tendency than that of a conductive material composing the one electrode that can be oxidized, the oxide layer at the first interface can be formed in the same atmosphere with improved certainty without an operation such as the formation of a protective layer for delaying the oxidation at the second interface during oxidation, and the first and second interfaces can be allowed to have different barrier levels.

The connection configuration forming step is also preferably a step of forming a pair of electrodes from different materials. In this case, stable properties can be obtained and productivity is increased because barrier levels can be made different according to material physical properties.

In a preferred mode, for example, the connection configuration forming step includes a step of modifying the surface of the carrier transporter at the first interface or the second interface to generate a difference between a degree of adhesion between the one electrode and the carrier transporter at the first interface and a degree of adhesion between the other electrode and the carrier transporter at the second interface, or the connection configuration forming step includes a step of forming an adhesion force adjusting layer on at least one of the first interface and the second interface to generate a difference between a degree of adhesion between the one electrode and the carrier transporter at the first interface and a degree of adhesion between the other electrode and the carrier transporter at the second interface. With such approach, barrier levels can be made different by utilizing rectifying properties resulting from the degree of adhesion or a distance between the electrode and the carrier transporter.

As described above, the rectifying device of the present invention using a carrier transporter composed of a carbon nanotube exerts an action as a carrier transporter even if a carrier moving path lengthens. Therefore, extremely high productivity can be obtained because, without through a lowly productive step of arranging electrodes on a single carbon nanotube having semiconductor properties, a rectifying device can be formed by forming electrodes on a network structure of carbon nanotubes having a larger size. In the case where one electrode is formed of a material that can be oxidized, and is oxidized to form an oxide layer, the surface of the electrode can be efficiently oxidized by oxygen to be supplied through the network of the network structure.

The carrier transporter may be formed by a network structure in which multiple carbon nanotubes which are not chemically bonded together are entangled. However, the formation of a network structure through entanglement of carbon nanotubes is not relatively suited for a reduction in size because the carbon nanotubes are apt to be bundled and hence the network structure is apt to be rough. In addition, the properties of the network structure are apt to change owing to the deformation of the structure. On the other hand, the use of a carbon nanotube structure having a network structure in which multiple carbon nanotubes are chemically bonded via cross-linked sites is effective because the network structure can be easily dense since the carbon nanotubes are fixed at the cross-linked sites, the structure shows small fluctuations in properties when reduced in size, and the structure shows small changes in properties even if it is deformed.

For this reason, in the present invention, it is preferable that the method include, prior to the connection formation forming step, a carrier transporter forming step of forming the carrier transporter, and the step include:
a supplying step of supplying the surface of the base body with multiple carbon nanotubes having functional groups; and
a cross-linking step of cross-linking the functional groups via cross-linked sites to form the carbon nanotube structure having the network structure.

At this time, it is particularly preferable that the supplying step include a supplying step of applying a solution containing the carbon nanotubes having the functional groups to the surface of the base body, and the carbon nanotube structure be filmy. In this case, in the step of supplying the surface of the base body with a solution containing multiple carbon nanotubes having functional groups (which may hereinafter be referred to as "a cross-linking solution"), the solution is applied to the entire surface of the base body or part of the surface thereof. Then, in the subsequent cross-linking step, the solution after the application is cured to form a carbon nanotube structure having a network structure in which the multiple carbon nanotubes mutually cross-link via chemical bonding of the functional groups. Through the above two steps, the structure itself of the carbon nanotube structure is stabilized on the surface of the base body.

The multiple carbon nanotubes may be single-wall carbon nanotubes or multi-wall carbon nanotubes. When they are mainly composed of single-wall carbon nanotubes, a carbon nanotube structure can be formed at high density, so a reduction in performance of a carrier transporter is small even when microprocessing such as patterning is performed. On the other hand, when they are mainly composed of multi-wall carbon nanotubes, the allowable maximum current of a multi-wall carbon nanotube as a conductor is larger than that of a single-wall carbon nanotube, so applications as a rectifier can be expanded. Furthermore, a multi-wall carbon nanotube is hardly bundled as compared to a single-wall carbon nanotube, so it is excellent in uniformity of properties. A multi-wall carbon nanotube is preferable also in terms of production because it can be produced at low cost and can be easily handled.

The carbon nanotube structure may be formed in a state where single-wall and multi-wall carbon nanotubes are mixed. In this case, the properties of both the single-wall and multi-wall carbon nanotubes can be utilized. In the cross-linking step to be described later, a first structure is formed by means of a cross-linking solution mainly composed of single-wall carbon nanotubes, and then a carbon nanotube structure may be formed by means of a cross-linking solution mainly composed of multi-wall carbon nanotubes so as to be combined with the first structure. The order in which single-wall and multi-wall carbon nanotubes are used may be reversed. At this time, when a cross-linking solution mainly composed of multi-wall carbon nanotubes is used, and then a cross-linking solution mainly composed of single-wall carbon nanotubes is used, gaps of a structure using multi-wall carbon nanotubes for its skeleton are combined with single-wall carbon nanotubes, so a structure having a large area can be manufactured efficiently.

In a first method preferable for cross-linking the functional groups in the cross-linking step to form cross-linked sites, the supplying step includes supplying a cross-linking agent for cross-linking the functional groups to the surface of the base body. The multiple functional groups are cross-linked with the cross-linking agent.

In the first method, a non-self-polymerizable cross-linking agent is preferably used as the cross-linking agent. When a self-polymerizable cross-linking agent is used as the cross-linking agent and cross-linking agents mutually cause a polymerization reaction during or before the cross-linking reaction in the cross-linking step, the bond between cross-linking agents is enlarged and elongated, and thereby, a gap itself between carbon nanotubes bonded to them inevitably extremely increases. At this time, it is in fact difficult to control the degree of reaction due to the self-polymerizability of cross-linking agents, so that the cross-linking structure between carbon nanotubes varies depending on variations in the polymerization state of cross-linking agents.

However, when a non-self-polymerizable cross-linking agent is used, cross-linking agents do not mutually polymerize at least during or before the cross-linking step. In addition, in the cross-linked site between carbon nanotubes, only a residue of the cross-linking agent by one cross-linking reaction is present as a connecting group between the residues of the functional group remaining after a cross-linking reaction. As a result, the carbon nanotube structure to be obtained has entirely uniformized characteristics. Even when the layer is patterned in the patterning step, variations in characteristics of the carbon nanotube structure after the patterning can be significantly reduced.

In addition, as long as the cross-linking agents do not cross-link, even when multiple kinds of non-self-polymerizable cross-linking agents are mixed to cross-link carbon nanotubes, a gap between carbon nanotubes can be controlled. Therefore, a similar reducing effect on the variations can be obtained. On the other hand, in the case where carbon nanotubes are cross-linked by using different cross-linking agents in a stepwise manner, when carbon nanotubes are cross-linked by using a non-self-polymerizable cross-linking agent at the initial cross-linking stage, the skeleton of the network structure of carbon nanotubes is completed in a state where a distance between carbon nanotubes is controlled. Therefore, a self-polymerizable cross-linking agent or a cross-linking agent that cross-links the initial cross-linking agent (or a residue thereof) may be used in the subsequent cross-linking step.

In the method of manufacturing a rectifying device of the present invention, examples of the functional groups for forming a cross-linked site by using a cross-linking agent include -OH, -COOH, -COOR (where R represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of which may be substituted), -COX (where X represents a halogen atom), -NH₂, and -NCO. It is preferable to select at least one functional group from the group consisting of the above functional groups. In such a case, a cross-linking agent, which may prompt a cross-linking reaction with the selected functional group, is selected as the cross-linking agent.

Further, preferable examples of the cross-linking agent include a polyol, a polyamine, a polycarboxylic acid, a polycarboxylate, a polycarboxylic acid halide, a polycarbodiimide, and a polyisocyanate. It is preferable to select at least one cross-linking agent from the group consisting of the above cross-linking agents. In such a case, a functional group, which may prompt a cross-linking reaction with the selected cross-linking agent, is selected as the functional group.

The at least one functional group and the at least one cross-linking agent are preferably selected respectively from the group consisting of the functional groups exemplified as the preferable functional groups and the group consisting of the cross-linking agents exemplified as the preferable cross-linking agents, such that a combination of the functional group and the cross-linking agent thus selected may prompt a mutual cross-linking reaction.

Particularly preferable examples of the functional group include -COOR (where R represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of which may be substituted). A carboxyl group can be introduced into a carbon nanotube with relative ease, and the resultant substance (carbon nanotube carboxylic acid) has high reactivity. Therefore, it is relatively easy to esterify the substance to convert its functional group into -COOR (where R represents the same as that described above) after the formation of the substance. The functional group easily prompts a cross-linking reaction, and is suitable for the formation of a coat.

In addition, a polyol can be exemplified as the cross-linking agent corresponding to the functional group. A polyol is cured by a reaction with -COOR (where R represents the same as that described above) to easily form a robust cross-linked substance. Out of polyols, each of glycerin, ethylene glycol, butenediol, hexynediol, hydroquinone, and naphthalenediol reacts with the above functional groups well. Moreover, each of glycerin, ethylene glycol, butenediol, hexynediol, hydroquinone, and naphthalenediol itself is highly biodegradable, and provides a low environmental load. Therefore, it is particularly preferable to use at least one selected from the group consisting of the above polyols as the cross-linking agent.

In the method of manufacturing a rectifying device of the present invention, in the case of the first method, the solution to be used in the supplying step containing the multiple carbon nanotubes to which the functional groups are bonded and the cross-linking agent may further contain a solvent, and the solution may be supplied to the surface of the base body. The cross-linking agent can also serve as the solvent depending on the kind of the cross-linking agent.

Further, a second method preferable for cross-linking the functional groups in the cross-linking step to form cross-linked sites is a method of chemically bonding the multiple functional groups together.

By following the second method, the size of the cross-linked site for bonding the carbon nanotubes together becomes constant depending on the functional group to be bonded. Since a carbon nanotube has an extremely stable chemical structure, there is a low possibility that functional groups or the like other than a functional group to modify the carbon nanotube are bonded to the carbon nanotube. In the case where the functional groups are chemically bonded together, the designed structure of the cross-linked site can be obtained, thereby providing a homogeneous carbon nanotube structure.

Furthermore, the functional groups are chemically bonded together, so that the length of the cross-linked site between the carbon nanotubes can be shorter than that in the case where the functional groups are cross-linked together with a cross-linking agent. Therefore, the carbon nanotube structure is dense, and tends to readily provide an effect peculiar to a carbon nanotube.

A reaction for chemically bonding the functional groups is particularly preferably one of a condensation reaction, a substitution reaction, an addition reaction, and an oxidative reaction. An additive for chemically bonding the functional groups may be additionally supplied to the surface of the base body in the supplying step.

When the reaction for chemically bonding the functional groups together is dehydration condensation, a condensation agent is preferably added as the additive. At least one selected from the group consisting of sulfuric acid, N-ethyl-N'-(3-dimethylaminopropyl)carbodiimide, and dicyclohexyl carbodiimide can be exemplified as a condensation agent that can be suitably used at this time.

The functional groups to be used in dehydration condensation are preferably at least one functional group selected from the group consisting of -COOR (where R represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of whichmaybe substituted), -COOH, -COX (where X represents a halogen atom), -OH, -CHO, and -NH₂.

Examples of the functional group particularly preferable for use in dehydration condensation include -COOH. Introduction of a carboxyl group into carbon nanotubes is relatively easy, and the resultant substance (carbon nanotube carboxylic acid) has high reactivity. Therefore, functional groups for forming a network structure can be easily introduced into multiple sites of one carbon nanotube. Moreover, the functional group is suitable for formation of a carbon nanotube structure because the functional group is easily subjected to dehydration condensation.

When the reaction for chemically bonding the functional groups together is a substitution reaction, a base is preferably added as the additive. At least one selected from the group consisting of sodium hydroxide, potassium hydroxide, pyridine, and sodium ethoxide can be exemplified as a base that can be suitably used at this time. In addition, the functional groups at this time are preferably at least one functional group selected from the group consisting of -NH₂, -X (where X represents a halogen atom), -SH, -OH, -OSO₂CH₃, and -OSO₂(C₆H₄)CH₃.

When the reaction for chemically bonding the functional groups together is an addition reaction, the functional groups are preferably -OH and/or -NCO.

When the reaction for chemically bonding the functional groups together is an oxidative reaction, the functional groups are preferably -SH. In this case, the additive is not always necessary. However, in a preferred mode, an oxidative reaction accelerator is added as the additive. An example of the oxidative reaction accelerator that can be suitably added is iodine.

In the method of manufacturing a rectifying device of the present invention, in the case of the second method, the multiple carbon nanotubes to which the functional groups are bonded to be used in the supplying step, and, as required, the additive may be incorporated into a solvent to prepare a solution for supply (cross-linking solution), and the cross-linking solution may be supplied to the surface of the base body.

In the manufacturing method of the present invention, it is more preferable that:
the carrier transporter be formed by a carbon nanotube structure having a network structure in which the multiple carbon nanotubes mutually cross-link; and
the method further include a patterning step of patterning the carbon nanotube structure into a pattern corresponding to the carrier transporter. When the method includes such patterning step, the carbon nanotube structure can be patterned into a pattern corresponding to the carrier transporter. At this stage, the structure itself of the carbon nanotube structure has been already stabilized in the cross-linking step. Since the patterning is performed in this state, there is no possibility that a problem in that a carbon nanotube scatters in the patterning step occurs.
Therefore, the structure can be patterned into a pattern corresponding to the carrier transporter. In addition, the film itself of the carbon nanotube structure is structured. Thus, connection between carbon nanotubes is surely secured, whereby a rectifying device utilizing characteristics of carbon nanotubes can be formed.

The patterning step includes the following two modes A and B.
A: A mode in which the patterning step is a step in which the carbon nanotube structure in a region on the surface of the base body other than a region having the pattern corresponding to the carrier transporter is subjected to dry etching to remove the carbon nanotube structure in the region, whereby the carbon nanotube structure is patterned into a pattern corresponding to the carrier transporter.

Examples of the operation of patterning the carbon nanotube structure into a pattern corresponding to the carrier transporter include a mode in which the patterning step further includes:
a resist layer forming step of forming a resist layer (preferably, a resin layer) above the carbon nanotube structure in a region on the surface of the base body having the pattern corresponding to the carrier transporter; and
a removing step of removing the carbon nanotube structure exposed in a region other than the above-described region by subjecting a surface of the base body on which the carbon nanotube structure and the resist layer are laminated to dry etching (Preferably, the surface is irradiated with an oxygen molecule radical. The oxygen molecule radical canbe generated by irradiating oxygen molecules with ultraviolet rays and the resultant oxygen radical is used).

In this case, a resist layer peeling-off step of peeling off the resist layer formed in the resist layer forming step is provided subsequent to the removing step, whereby the patterned carbon nanotube structure can be exposed.

In addition, in this mode, examples of the operation of patterning the carbon nanotube structure into the pattern corresponding to the carrier transporter include a mode of patterning the carbon nanotube structure into the pattern corresponding to the carrier transporter by selectively irradiating the carbon nanotube structure in a region of the surface of the base body other than the region having the pattern corresponding to the carrier transporter with an ion beam of a gas molecule to remove the carbon nanotube structure in the region.
B: A mode in which the patterning step includes:
   a resist layer forming step of forming a resist layer above the carbon nanotube structure in a region on the surface of the base body having the pattern corresponding to the carrier transporter; and
   a removing step of removing the carbon nanotube structure exposed in a region other than the above-described region by bringing a surface of the base body on which the carbon nanotube structure and the resist layer are laminated into contact with an etchant.

As described above, according to the present invention, there can be provided: a rectifying device using a carrier transporter composed of a carbon nanotube to provide reproducibility of a rectifying direction; an electronic circuit using the rectifying device; and a method of manufacturing the rectifying device.

### BRIEF DESCRIPTION OF THE DRAWINGS

Fig. 1(a) is a schematic sectional diagram showing an embodiment of the structure of a rectifying device of the present invention.
Fig. 1(b) is a schematic sectional diagram showing another embodiment of the structure of the rectifying device of the present invention.
Fig. 1(c) is a schematic sectional diagram showing still another embodiment of the structure of the rectifying device of the present invention.
Fig. 2 (a) is a schematic sectional diagram of the surface of a base body for explaining an example of a method of manufacturing a rectifying device of the present invention, showing a state where a carbon nanotube structure layer is formed on the surface of the base body after a cross-linking step.
Fig. 2 (b) is a schematic sectional diagram of the surface of the base body for explaining the example of the method of manufacturing a rectifying device of the present invention, showing a state where a resist layer is formed on the entire surface on which the carbon nanotube structure layer has been formed in a resist layer forming step.
Fig. 2 (c) is a schematic sectional diagram of the surface of the base body for explaining the example of the method of manufacturing a rectifying device of the present invention, showing a state after the resist layer forming step.
Fig. 2 (d) is a schematic sectional diagram of the surface of the base body for explaining the example of the method of manufacturing a rectifying device of the present invention, showing a state after a removing step.
Fig. 2 (e) is a schematic sectional diagram of the surface of the base body for explaining the example of the method of manufacturing a rectifying device of the present invention, showing a state after a patterning step.
Fig. 2 (f) is a schematic sectional diagram of the surface of the base body for explaining the example of the method of manufacturing a rectifying device of the present invention, showing a rectifying device to be finally obtained.
Fig. 3 is a reaction scheme for the synthesis of a carbon nanotube carboxylic acid in (Addition Step) of Example 1.
Fig. 4 is a reaction scheme for esterification in (Addition Step) of Example 1.
Fig. 5 is a reaction scheme for cross-linking by an ester exchange reaction in (Cross-linking Step) of Example 1.
Fig. 6 is a schematic sectional diagram of a rectifying device of Example 3.
Fig. 7 is a graph showing current-voltage characteristics of the device of Example 1 obtained by current-voltage characteristic measurement in an evaluation test.
Fig. 8 is a graph showing current-voltage characteristics of the device of Example 2 obtained by current-voltage characteristic measurement in an evaluation test.
Fig. 9 is a graph showing current-voltage characteristics of the device of Example 3 obtained by current-voltage characteristic measurement in an evaluation test.
Fig. 10(a) is a schematic sectional diagram of the surface of a base body and a temporary substrate for explaining a useful applied example of the method of manufacturing a rectifying device of the present invention, showing a state of the base body where a carbon nanotube structure is formed and patterned into a shape corresponding to a transporting layer.
Fig. 10(b) is a schematic sectional diagram of the surface of the base body and the temporary substrate for explaining the useful applied example of the method of manufacturing a rectifying device of the present invention, showing a state before the temporary substrate is attached to the base body of Fig. 10(a).
Fig. 10(c) is a schematic sectional diagram of the surface of the base body and the temporary substrate for explaining the useful applied example of the method of manufacturing a rectifying device of the present invention, showing a state after the temporary substrate has been attached to the base body of Fig. 10(a).
Fig. 10(d) is a schematic sectional diagram of the surface of the base body and the temporary substrate for explaining the useful applied example of the method of manufacturing a rectifying device of the present invention, showing a state after the temporary substrate attached to the base body of Fig. 10(a) has been peeled off again.
Fig. 10(e) is a schematic sectional diagram of the surface of the base body and the temporary substrate for explaining the useful applied example of the method of manufacturing a rectifying device of the present invention, showing two rectifying devices to be finally obtained simultaneously.

### BEST MODE FOR CARRYING OUT THE INVENTION

Hereinafter, the present invention will be described in detail with respect to a rectifying device and a method of manufacturing the same.

### [Rectifying Device]

A rectifying device of the present invention includes: a pair of electrodes; and a carrier transporter arranged between the pair of electrodes and composed of one or multiple carbon nanotubes, and is characterized in that a first connection configuration between one electrode of the pair of electrodes and the carrier transporter and a second connection configuration between the other electrode of the pair of electrodes and the carrier transporter are made different from each other in such a manner that a first interface between the one electrode and the carrier transporter and a second interface between the other electrode and the carrier transporter have different barrier levels.

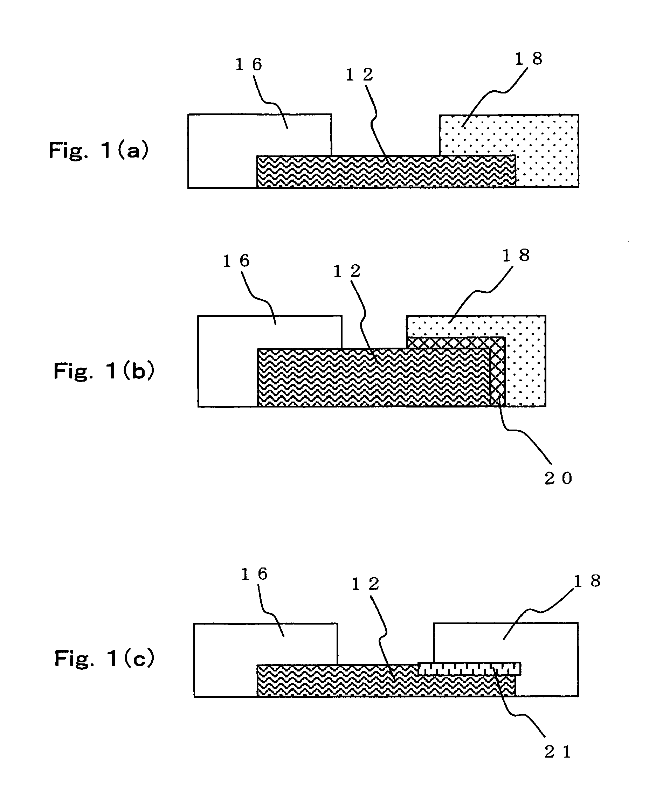

Figs. 1 show several embodiments of the structure of the rectifying device of the present invention.

In a first embodiment, a carrier transporter 10 is composed of a carbon nanotube structure, and a pair of electrodes 16 and 18 composed of different materials is connected to make a first connection configuration and a second connection configuration different from each other, to thereby form different barrier levels at a first interface and a second interface. Thus, the first and second connection configurations are made different to allow the entirety to operate as a rectifying device (Fig. 1(a)).

In a second embodiment, an oxide layer (oxide film) 20 is formed at the first interface between the carrier transporter 10 and the one electrode 18 to make the first connection configuration and the second connection configuration different from each other (Fig. 1(b)).

In a third embodiment, the surface of the carrier transporter 10 at the first interface is modified or processed, or a material for reducing or increasing the degree of adhesion with an electrode is, for example, applied to place a dissimilar connection layer 21 at the first interface between the carrier transporter 10 and the one electrode 18, thereby making the first connection configuration and the second connection configuration different from each other. In addition, the degree of adhesion between the second electrode and the carrier transporter 10 at the second interface is made different to form different barrier levels (Fig. 1(c)).

In addition to the foregoing, it is needless to say that an arbitrary combination of an electrode material, an oxide layer, and the processing of a carrier transporter can also make the first and second connection configurations different from each other.

The carrier transporter 10 is composed of a carbon nanotube. A single carbon nanotube is metallicor semiconductive. When a single carbon nanotube is used for the carrier transporter, a semiconductive carbon nanotube must be used. On the other hand, the research conducted by the inventors of the present invention have revealed that, when the carrier transporter is composed of multiple carbon nanotubes, the carrier transporter may exert semiconductor properties even if the carbon nanotubes are metallic. Tobe specific, a carbon nanotube structure having a network structure formed via cross-linked sites corresponds to the case. This will be described in detail later. When the carbon nanotubes are semiconductive, the carrier transporter exerts semiconductor properties even if it does not have a cross-linking structure. Therefore, a structure having a network structure formed through entanglement of carbon nanotubes may also be used as the carrier transporter of the present invention.

In forming a rectifying device, a carrier transporter having a carbon nanotube structure can be processed into a desired shape through patterning. In this case, depending on the shape of a base body, for example, the carbon nanotube structure can be patterned directly on the surface of the base body, a base body carrying a patterned carbon nanotube structure is attached to a second base body, or only a patterned carbon nanotube structure is transferred.

A material for a base body is not particularly limited, but is preferably silicon, a quartz substrate, mica, quartz glass, or the like for easily performing a patterning process to carry a transporting layer (carrier transporter) of a rectifying device.

However, it may be impossible to pattern a carbon nanotube structure directly on the surface of a base body depending on the shape and nature of the base body. In such case, for example, a base body carrying a patterned carbon nanotube structure is attached to a second base body, or a patterned carbon nanotube structure is transferred. By doing so, there will be a reduced number of limitations on the base body carrying a final rectifying device.

In particular, the rectifying device of the present invention can be easily manufactured as described below even when a base body having plasticity or flexibility is used as a substrate. Moreover, the carbon nanotube structure formed on the surface has a cross-linking structure, so there is a low possibility that the carbon nanotube structure on the surface is broken when the substrate is bent. As a result, the deterioration of the performance of the device due to deformation is reduced. In particular, when the device is used as a rectifying device, the occurrence of breaking of wire due to bending is reduced.

Examples of a substrate having plasticity or flexibility include various resins such as polyethylene, polypropylene, polyvinyl chloride, polyamide, and polyimide.

### <Carbon Nanotube Structure>

In the present invention, the term "carbon nanotube structure" refers to a structure having a network structure constructed by mutually cross-linking multiple carbon nanotubes. Provided that a carbon nanotube structure can be formed in such a manner that carbon nanotubes mutually cross-link to construct a network structure, the carbon nanotube structure may be formed through any method. However, the carbon nanotube structure is preferably manufactured through a method of manufacturing a rectifying device of the present invention described later for easy manufacture, a low-cost and high-performance carrier transporter, and easy uniformization and control of characteristics.

A first structure for the carbon nanotube structure having a network structure, in which carbon nanotubes mutually cross-link, to be used as a carrier transporter in the rectifying device of the present invention manufactured by a preferable method of manufacturing a rectifying device of the present invention described later is manufactured by curing a solution (cross-linking solution) containing carbon nanotubes having functional groups and a cross-linking agent that prompts a cross-linking reaction with the functional groups, to prompt a cross-linking reaction between the functional groups of the carbon nanotubes and the cross-linking agent, to thereby form a cross-linked site. Furthermore, a second structure for the carbon nanotube structure is manufactured by chemically bonding together functional groups of carbon nanotubes to form cross-linked sites.

Hereinafter, the carbon nanotube structure in the rectifying device of the present invention will be described by way of examples of the manufacturing method.

### (Carbon Nanotube)

Carbon nanotubes, which are the main component in the present invention, may be single-wall carbon nanotubes or multi-wall carbon nanotubes each having two or more layers. Whether one or both types of carbon nanotubes are used (and, if only one type is used, which type is selected) may be decided appropriately taking into consideration the use of the rectifying device or the cost. When a single carbon nanotube is used for a carrier transporter, the carbon nanotube must be semiconductive.

Carbon nanotubes in the present invention include ones that are not exactly shaped like a tube, such as: a carbon nanohorn (a horn-shaped carbon nanotube whose diameter continuously increases from one end toward the other end) which is a variant of a single-wall carbon nanotube; a carbon nanocoil (a coil-shaped carbon nanotube forming a spiral when viewed in entirety); a carbon nanobead (a spherical bead made of amorphous carbon or the like with its center pierced by a tube); a cup-stacked nanotube; and a carbon nanotube with its outer periphery covered with a carbon nanohorn or amorphous carbon.

Furthermore, carbon nanotubes in the present invention may include ones that contain some substances inside, such as: a metal-containing nanotube which is a carbon nanotube containing metal or the like; and a peapod nanotube which is a carbon nanotube containing a fullerene or a metal-containing fullerene.

As described above, in the present invention, it is possible to employ carbon nanotubes of any form, including common carbon nanotubes, variants of the common carbon nanotubes, and carbon nanotubes with various modifications, without a problem in terms of reactivity. Therefore, the concept of "carbon nanotube" in the present invention encompasses all of the above.

Those carbon nanotubes are conventionally synthesized through a known method such as arc discharge, laser ablation, or CVD, and the present invention can employ any of the methods without any limitation. However, arc discharge in a magnetic field is preferable from the viewpoint of synthesizing a highly pure carbon nanotube.

The diameter of a carbon nanotube used in the present invention is preferably 0.3 nm or more and 100 nm or less. A diameter of the carbon nanotube exceeding this upper limit undesirably results in difficult and costly synthesis. A more preferable upper limit of the diameter of a carbon nanotube is 30 nm or less.

In general, the lower limit of the carbon nanotube diameter is about 0.3 nm from a structural standpoint. However, too small a diameter could undesirably lower the synthesis yield. It is therefore preferable to set the lower limit of the carbon nanotube diameter to 1 nm or more, more preferably 10 nm or more.

The length of a carbon nanotube used in the present invention is preferably 0.1 µm or more and 100 µm or less. A length of the carbon nanotube exceeding this upper limit undesirably results in difficult synthesis or requires a special synthesis method raising cost. On the other hand, a length of the carbon nanotube falling short of this lower limit undesirably reduces the number of cross-link bonding points per carbon nanotube. A more preferable upper limit of the carbon nanotube length is 10 µm or less, and a more preferable lower limit of the carbon nanotube length is 1 µm or more.

The purity of the carbon nanotubes to be used is desirably raised by purifying the carbon nanotubes before preparation of the cross-linking solution if the purity is not high enough. In the present invention, the higher the carbon nanotube purity, the better the result can be. Specifically, the purity is preferably 90% or higher, more preferably 95% or higher. Low purity causes the cross-linking agent to cross-link with carbon products such as amorphous carbon and tar, which are impurities. This could change the cross-linking distance between carbon nanotubes, and desired characteristics may not be obtained. A purification method for carbon nanotubes is not particularly limited, and any known purification method can be employed.

Such carbon nanotubes are used for the formation of a carbon nanotube structure with predetermined functional groups added to the carbon nanotubes. A preferable functional group to be added at this time varies depending on whether the carbon nanotube structure is formed through the first method or second method described above (a preferable functional group in the former case is referred to as "Functional Group 1", and a preferable functional group in the latter case is referred to as "Functional Group 2").

How functional groups are introduced into carbon nanotubes will be described in the section below titled (Method of Preparing Cross-linking Solution).

Hereinafter, components that can be used for the formation of a carbon nanotube structure will be described for the respective first and second methods.

### (Case of First Method)

In the present invention, carbon nanotubes can have any functional groups to be connected thereto without particular limitations, as long as functional groups selected can be added to the carbon nanotubes chemically and can prompt a cross-linking reaction with any type of cross-linking agent. Specific examples of such functional groups include -COOR, -COX, -MgX, -X (where X represents halogen), -OR, -NR¹R², -NCO, -NCS, -COOH, -OH, -NH₂, -SH, -SO₃H, -R'CHOH, -CHO, -CN, -COSH, -SR, -SiR' ₃ (In the above formulae, R, R¹, R², and R' each independently represent a substituted or unsubstituted hydrocarbon group. Those are each preferably independently selected from -CₙH₂ₙ₋₁, -CₙH₂ₙ, and -CₙH₂ₙ+1 (where n represents an integer of 1 to 10) each of which may be substituted. Of those, a methyl group or an ethyl group is more preferable for each of them.). Note that the functional groups are not limited to those examples.

Of those, it is preferable to select at least one functional group from the group consisting of -OH, -COOH, -COOR (where R represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of which may be substituted), -COX (where X represents a halogen atom), -NH₂, and -NCO. In that case, a cross-linking agent, which can prompt a cross-linking reaction with the selected functional group, is selected as the cross-linking agent.

In particular, -COOR (R is the same as that described above) is particularly preferable. This is because a carboxyl group can be introduced into a carbon nanotube with relative ease, because the resultant substance (carbon nanotube carboxylic acid) can be easily introduced as a functional group by esterifying the substance, and because the substance has good reactivity with a cross-linking agent.

R in the functional group -COOR is a substituted or unsubstituted hydrocarbon group, and is not particularly limited. However, R is preferably an alkyl group having 1 to 10 carbon atoms, more preferably an alkyl group having 1 to 5 carbon atoms, and particularly preferably a methyl group or an ethyl group in terms of reactivity, solubility, viscosity, and ease of use as a solvent for a cross-linking solution.

The amount of functional groups introduced cannot be determined uniquely because the amount varies depending on the length and thickness of a carbon nanotube, whether the carbon nanotube is of a single-wall type or a multi-wall type, the type of a functional group, the use of the rectifying device, etc. From the viewpoint of the strength of the cross-linked substance obtained, namely, the strength of the coat, a preferable amount of functional groups introduced is large enough to add two or more functional groups to each carbon nanotube.

How functional groups are introduced into carbon nanotubes will be described in the section below titled [Method of Manufacturing

### Rectifying Device].

### (Cross-linking Agent)

A cross-linking agent is an essential ingredient in the first method. Any cross-linking agent can be used as long as the cross-linking agent is capable of prompting a cross-linking reaction with the functional groups of the carbon nanotubes. In other words, the type of cross-linking agent that can be selected is limited to a certain degree by the types of the functional groups. In addition, the conditions of curing (heating, UV irradiation, visible light irradiation, air setting, etc.) as a result of the cross-linking reaction are naturally determined by the combination of those parameters.

Specific examples of the preferable cross-linking agent include a polyol, a polyamine, a polycarboxylic acid, a polycarboxylate, a polycarboxylic acid halide, a polycarbodiimide, and a polyisocyanate. It is preferable to select at least one cross-lining agent from the group consisting of the above cross-linking agents. In that case, a functional group which can prompt a reaction with the selected cross-linking agent is selected as the functional group.

At least one functional group and at least one cross-linking agent are particularly preferably selected respectively from the group consisting of the functional groups exemplified as the preferable functional groups and the group consisting of the cross-linking agents exemplified as the preferable cross-linking agents, so that a combination of the functional group and the cross-linking agent may prompt a cross-linking reaction with each other. The following Table 1 lists the combinations of the functional group of the carbon nanotubes and the corresponding cross-linking agent, which can prompt a cross-linking reaction, along with curing conditions for the combinations.

**(Table 1)**

| Functional group of carbon nanotube | Cross-linking agent | Curing condition |
|---|---|---|
| -COOR | Polyol | heat curing |
| -COX | Polyol | heat curing |
| -COOH | Polyamine | heat curing |
| -COX | Polyamine | heat curing |
| -OH | Polycarboxylate | heat curing |
| -OH | Polycarboxylic acid halide | heat curing |
| -NH₂ | Polycarboxylic acid | heat curing |
| -NH₂ | Polycarboxylic acid halide | heat curing |
| -COOH | Polycarbodiimide | heat curing |
| -OH | Polycarbodiimide | heat curing |
| -NH₂ | Polycarbodiimide | heat curing |
| -NCO | Polyol | heat curing |
| -OH | Polyisocyanate | heat curing |
| -COOH | Ammonium complex | heat curing |
| -COOH | Hydroquinone | heat curing |

| | | |
|---|---|---|
| *R represents a substituted or unsubstituted hydrocarbon group | | |
| *X represents a halogen | | |

Of those combinations, preferable is the combination of -COOR (where R represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of which may be substituted) with good reactivity on the functional group side and a polyol, a polyamine, an ammonium complex, congo red, and cis-platin, which form a robust cross-linked substance with ease.

The term "polyol" as used in the present invention is a generic name for organic compounds each having two or more OH groups. Of those, one having 2 to 10 (more preferably 2 to 5) carbon atoms and 2 to 22 (more preferably 2 to 5) OH groups is preferable in terms of cross-linkability, solvent compatibility when an excessive amount thereof is charged, treatability of waste solution after a reaction by virtue of biodegradability (environmental suitability), yield of polyol synthesis, and so on. In particular, the number of carbon atoms is preferably lower within the above range because a gap between carbon nanotubes in the resultant coat can be extremely narrowed to bring the carbon nanotubes into substantial contact state with each other (to bring the carbon nanotubes close to each other). Specifically, glycerin and ethylene glycol are particularly preferable, and one or both of glycerin and ethylene glycol are preferably used as a cross-linking agent.

From another perspective, the cross-linking agent is preferably a non-self-polymerizable cross-linking agent. In addition to glycerin and ethylene glycol as examples of the polyols mentioned above, butenediol, hexynediol, hydroquinone, and naphthalenediol are obviously non-self-polymerizable cross-linking agents. More generally, a prerequisite for the non-self-polymerizable cross-linking agent is to be without a pair of functional groups, which can prompt a polymerization reaction with each other, in itself. On the other hand, examples of a self-polymerizable cross-linking agent include one that has a pair of functional groups, which can prompt a polymerization reaction with each other (alkoxide, for example), in itself.

Formation of a carbon nanotube structure only involves: supplying the base body surface with the multiple carbon nanotubes to which functional groups are bonded and the cross-linking agent (the supplying step in the method of manufacturing a rectifying device of the present invention); and chemically bonding the functional groups together to form a cross-linked site (the cross-linking step in the method of manufacturing a rectifying device of the present invention). In supplying the base body surface with the multiple carbon nanotubes to which functional groups are bonded and the cross-linking agent, the base body surface is preferably supplied with a solution (cross-linking solution) containing the carbon nanotubes, the cross-linking agent, and a solvent. In particular, the solution is preferably applied as an application solution to form a cross-linked substance film, for a simple, low cost, operation in a short period of time.

The appropriate carbon nanotube content in the cross-linking solution varies depending on the length and thickness of carbon nanotubes, whether single-wall carbon nanotubes or multi-wall carbon nanotubes are used, the type and amount of functional groups in the carbon nanotubes, the type and amount of cross-linking agents, the presence or absence of a solvent or other additive used and, if one is used, the type and amount of the solvent or additive, etc. The carbon nanotube content in the solution should be high enough to form an excellent coat after curing but not be excessively high because the application suitability lowers.

Specifically, the ratio of carbon nanotubes to the entire solution excluding the mass of the functional groups is about 0.01 to 10 g/l, preferably about 0.1 to 5 g/l, and more preferably about 0.5 to 1.5 g/l, although, as mentioned above, the ranges could be different if the parameters are different.

A solvent is added when satisfactory application suitability of the cross-linking solution is not achieved with solely the cross-linking agents. A solvent that can be employed is not particularly limited, and may be appropriately selected according to the type of the cross-linking agent to be used. Specific examples of employable solvents include: organic solvents such as methanol, ethanol, isopropanol, n-propanol, butanol, methyl ethyl ketone, toluene, benzene, acetone, chloroform, methylene chloride, acetonitrile, diethyl ether, and tetrahydrofuran (THF); water; aqueous solutions of acids; and alkaline aqueous solutions. A solvent as such is added in an amount that is not particularly limited but determined appropriately by taking into consideration the application suitability of the cross-linking solution.

However, out of the above-described solvents, only glycerin is preferably used as a cross-linking agent and a solvent, for example, because the viscosity at the time when a carbon nanotube as a solute is dispersed is not high, because glycerin is excellent in application suitability when turned into a film, because glycerin has good properties as a cross-linking agent with respect to a carboxylic acid, and because the remainder after a cross-linking reaction does not adversely affect.

### (Case of Second Method)

In the second method for forming a cross-linked site by directly chemically bonding multiple functional groups bonded to carbon nanotubes irrespective of what cross-linking agent is used, the functional groups in the carbon nanotubes are not particularly limited as long as the functional groups can be chemically added to the carbon nanotubes and are capable of reacting with each other using some type of additive, and any type of functional group can be selected.

Specific examples of the functional group include -COOR, -COX, -MgX, -X (where X represents a halogen), -OR, -NR¹R², -NCO, -NCS, -COOH, -OH, -NH₂, -SH, -SO₃H, -R'CHOH, -CHO, -CN, -COSH, -SR, -SiR'₃ (In the above formulae, R, R¹, R², and R' each independently represent a substituted or unsubstituted hydrocarbon group. Those are each preferably independently selected from -CₙH₂ₙ₋₁, -CₙH₂ₙ, and -CₙH₂ₙ₊₁ (where n represents an integer of 1 to 10) each of which may be substituted. Of those, a methyl group or an ethyl group is more preferable.). However, the functional group is not limited to those.

A reaction for chemically bonding the functional groups together is particularly preferably dehydration condensation, a substitution reaction, an addition reaction, or an oxidative reaction. The functional groups preferable for the respective reactions out of the above functional groups are exemplified below. The functional groups to be used in dehydration condensation are preferably at least one functional group selected from the group consisting of -COOR (where R represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of which may be substituted), -COOH, -COX (where X represents a halogen atom), -OH, -CHO, and -NH₂. The functional groups to be used in a substitution reaction are preferably at least one functional group selected from the group consisting of -NH₂, -X (where X represents a halogen atom), -SH, -OH, -OSO₂CH₃, and -OSO₂(C₆H₄)CH₃. The functional groups to be used in an addition reaction are preferably -OH and/or -NCO. The functional groups to be used in an oxidative reaction are preferably -SH.

Further, it is also possible to bond a molecule, which partially contains those functional groups, with the carbon nanotubes to be chemically bonded at a preferable functional group portion exemplified above. Even in this case, a functional group with a large molecular weight to be bonded to the carbon nanotubes is bonded as intended, enabling control of a length of the cross-linked site.

In chemically bonding the functional groups together, an additive that can form the chemical bonding among the functional groups can be used. Any additive that is capable of causing the functional groups of the carbon nanotubes to react with each other can be used as such an additive. In other words, the type of additive that can be selected is limited to a certain degree by the types of the functional groups and the reaction. In addition, the conditions of curing (heating, UV irradiation, visible light irradiation, air setting, etc.) as a result of the reaction are naturally determined by the combination of those parameters.

When the reaction for chemically bonding the functional groups together is dehydration condensation, a condensation agent is preferably added as the additive. Specific examples of a preferable condensation agent as the additive include an acid catalyst and a dehydration condensation agent such as sulfuric acid, N-ethyl-N'-(3-dimethylaminopropyl)carbodiimide, and dicyclohexyl carbodiimide. It is preferable to select at least one condensation agent from the group consisting of the above. In that case, the functional groups, which can prompt a reaction among the functional groups with the help of the selected condensation agent, are selected as the functional groups.

The functional groups to be used in dehydration condensation are preferably at least one functional group selected from the group consisting of -COOR (R represents a substituted or unsubstituted hydrocarbon group), -COOH, -COX (where X represents a halogen atom), -OH, -CHO, and -NH₂.

Examples of the functional group particularly preferable for use in dehydration condensation include -COOH. Introduction of a carboxyl group into carbon nanotubes is relatively easy, and the resultant substance (carbon nanotube carboxylic acid) has high reactivity. Therefore, functional groups for forming a network structure can be easily introduced into multiple sites of one carbon nanotube. Moreover, the functional group is suitable for formation of a carbon nanotube structure because the functional group is easily subjected to dehydration condensation. If the functional group to be used in dehydration condensation is -COOH, sulfuric acid, N-ethyl-N'-(3-dimethylaminopropyl)carbodiimide, and dicyclohexyl carbodiimide described above are particularly preferable condensation agents.

When the reaction for chemically bonding the functional groups together is a substitution reaction, a base is preferably added as the additive. Abase that can be added is not particularly limited, and may be any base as long as the base is selected according to the acidity of a hydroxyl group.

Specific preferable examples of the base include sodium hydroxide, potassium hydroxide, pyridine, and sodium ethoxide. It is preferable to select at least one base from the group consisting of the above bases. In that case, functional groups, which can prompt a substitution reaction among the functional groups with the help of the selected base, are selected as the functional groups. In addition, the functional groups at this time are preferably at least one functional group selected from the group consisting of -NH₂, -X (where X represents a halogen atom), -SH, -OH, -OSO₂CH₃, and -OSO₂(C₆H₄)CH₃.

When the reaction for chemically bonding the functional groups together is an addition reaction, an additive is not always necessary. The functional groups at this time are preferably -OH and/or -NCO.

When the reaction for chemically bonding the functional groups together is an oxidative reaction, an additive is not always necessary either. However, an oxidative reaction accelerator is preferably added as the additive. An example of the oxidative reaction accelerator that can be suitably added is iodine. In addition, the functional groups at this time are preferably -SH.

It is preferable to select at least two functional groups to be added to carbon nanotubes from the group consisting of the functional groups exemplified as preferable functional groups so that a combination of the selected functional groups is capable of prompting a mutual reaction. Table 2 below lists functional groups (A) and (B) of carbon nanotubes capable of prompting a mutual cross-linking reaction and the names of corresponding reactions.

**(Table 2)**

| Linked site | Functional group of carbon nanotube (A) | Functional group of carbon nanotube (B) | Reaction |
|---|---|---|---|
| -COOCO- | -COOH | - | Dehydration condensation |
| -S-S- | -SH | - | Oxidative reaction |
| -O- | -OH | - | Dehydration condensation |
| -NH-CO- | -COOH | -NH₂ | Dehydration condensation |
| -COO- | -COOH | -OH | Dehydration condensation |
| -COO- | -COOR | -OH | Dehydration condensation |
| -COO- | -COX | -OH | Dehydration condensation |
| -CH=N- | -CHO | -NH₂ | Dehydration condensation |
| -NH- | -NH₂ | -X | Substitution reaction |
| -S- | -SH | -X | Substitution reaction |
| -O- | -OH | -X | Substitution reaction |
| -O- | -OH | -OSO₂CH₃ | Substitution reaction |
| -O- | -OH | -OSO₂(C₆H₄)CH₃ | Substitution reaction |
| -NH-COO- | -OH | -N=C=O | Addition reaction |

| | | | |
|---|---|---|---|
| *R represents a substituted or unsubstituted hydrocarbon group | | | |
| *X represents a halogen | | | |

Formation of a carbon nanotube structure only involves: supplying the base body surface with the multiple carbon nanotubes to which functional groups are bonded and the additive as required (supplying step in the method of manufacturing a rectifying device of the present invention); and chemically bonding the functional groups together to form a cross-linked site (cross-linking step in the method of manufacturing a rectifying device of the present invention). In supplying the base body surface with the multiple carbon nanotubes to which functional groups are bonded, the base body surface is preferably supplied with a solution (cross-linking solution) containing the carbon nanotubes and a solvent. In particular, the solution is preferably applied as an application solution to form a cross-linked substance film, for simple formation of the rectifying device of the present invention at a low cost and operation in a short period of time.

The idea for the content of the carbon nanotubes in the cross-linking solution is basically the same as that in the first method.

The content of a cross-linking agent in the cross-linking solution and the content of an additive for bonding a functional group vary depending on the type of the cross-linking agent (including whether the cross-linking agent is self-polymerizable or non-self-polymerizable). The content also varies depending on the length and thickness of a carbon nanotube, whether the carbon nanotube is of a single-wall type or a multi-wall type, the type and amount of a functional group of the carbon nanotube, the presence or absence of a solvent or other additives, and, if one is used, the type and amount thereof, and the like. Therefore, the content can not be determined uniquely. In particular, for example, glycerin or ethylene glycol can also provide characteristics of a solvent because the viscosity of glycerin or ethylene glycol is not so high, and thus an excessive amount of glycerin or ethylene glycol can be added.

A solvent is added when satisfactory, application suitability of the cross-linking solution is not achieved with solely the cross-linking agent or additive for bonding functional groups. A solvent that can be employed is not particularly limited, and may be appropriately selected according to the type of the additive to be used. Specific examples of an employable solvent and the addition amount thereof are the same as those in the first method.

### (Other Additive)

The cross-linking solution (used in both the first method and the secondmethod) may contain various additives including a solvent, a viscosity modifier, a dispersant, and a cross-linking accelerator.

A viscosity modifier is added when sufficient application suitability is not achieved solely with the cross-linking agent or the additive for bonding the functional groups. A viscosity modifier that can be employed is not particularly limited, and may be appropriately selected according to the type of cross-linking agent to be used. Specific examples of such a viscosity modifier include methanol, ethanol, isopropanol, n-propanol, butanol, methyl ethyl ketone, toluene, benzene, acetone, chloroform, methylene chloride, acetonitrile, diethyl ether, and THF.

Some of those viscosity modifiers serve as a solvent when added in a certain amount, but it is meaningless to clearly distinguish the viscosity modifier from the solvent. A viscosity modifier as such is added in an amount that is not particularly limited but determined appropriately by taking into consideration the application suitability.

A dispersant is added in order to maintain the dispersion stability of the carbon nanotubes, the cross-linking agent, or the additive for bonding the functional groups in the cross-linking solution. Various known surfactants, water-soluble organic solvents, water, acidic aqueous solutions, alkaline aqueous solutions, etc. can be employed as a dispersant. However, a dispersant is not always necessary since components of the cross-linking solution themselves have high dispersion stability. In addition, depending on the use of the coat after the formation, the presence of impurities such as a dispersant in the coat may not be desirable. In such a case, a dispersant is not added at all, or is added in a very small amount.

### <Method of Preparing Cross-linking Solution>

A method of preparing a cross-linking solution is described next.

The cross-linking solution is prepared by mixing carbon nanotubes that have functional groups with a cross-linking agent that prompts a cross-linking reaction with the functional groups or an additive for chemically bonding functional groups (mixing step) as required. The mixing step may be preceded by an addition step in which the functional groups are introduced into the carbon nanotubes.

Use of carbon nanotubes having functional groups as starting materials starts the preparation only from the mixing step. The use of normal carbon nanotubes themselves as starting materials starts the preparation from the addition step.

### (Addition Step)

The addition step is a step of introducing desired functional groups into carbon nanotubes. How functional groups are introduced varies depending on the type of functional group and cannot be determined uniquely. One method involves adding a desired functional group directly. Another method involves: introducing a functional group that is easily added; and then substituting the whole functional group or a part thereof, or adding a different functional group to the former functional group, in order to obtain the target functional group.

Still another method involves applying amechanochemical force to a carbon nanotube to break or modify a very small portion of a graphene sheet on the surface of the carbon nanotube, to thereby introduce various functional groups into the broken or modified portion.

Furthermore, functional groups can be relatively easily introduced into cup-stacked carbon nanotubes, which have many defects on the surface upon manufacture, and carbon nanotubes that are formed by vapor phase growth. On the other hand, carbon nanotubes each having a perfect graphene sheet structure exert the carbon nanotube characteristics more effectively and the characteristics are easily controlled. Consequently, it is particularly preferable to use a multi-wall carbon nanotube so that an appropriate number of defects are formed on its outermost layer as a carrier transporter to bond functional groups for cross-linking while the inner layers having less structural defects exert the carbon nanotube characteristics.

Operations for the addition step are not particularly limited, and any known method can be employed. Various addition methods disclosed in JP 2002-503204 Amay be employed in the present invention depending on the purpose.

A description is given on a method of introducing -COOR (where R represents a substituted or unsubstituted hydrocarbon group), a particularly desirable functional group among the functional groups listed above. To introduce -COOR (where R represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of which may be substituted) into carbon nanotubes, carboxyl groups may be added to the carbon nanotubes once (i), and then esterified (ii).

### (i) Addition of Carboxyl Group

To introduce carboxyl groups into carbon nanotubes, carboxyl groups are refluxed together with an acid having an oxidizing effect. This operation is relatively easy and is preferable since carboxyl groups with high reactivity can be added to carbon nanotubes. A brief description of the operation is given below.

Examples of an acid having an oxidizing effect include concentrated nitric acid, a hydrogen peroxide solution, a mixture of sulfuric acid and nitric acid, and aqua regia. Concentrated nitric acid is particularly used in concentration of preferably 5 mass% or higher, or more preferably 60 mass% or higher.

A normal reflux method can be employed. The reflux temperature is preferably close to the boiling point of the acid used. When concentrated nitric acid is used, for instance, the temperature is preferably set to 120°C to 130°C. The reflux preferably lasts for 30 minutes to 20 hours, or more preferably for 1 hour to 8 hours.

Carbon nanotubes to which carboxyl groups are added (carbon nanotube carboxylic acid) are produced in the reaction solution after the reflux. The reaction solution is cooled down to room temperature and then is subj ected to a separation operation or washing as required, thereby obtaining the target carbon nanotube carboxylic acid (a carbon nanotube having -COOH as a functional group).

### (ii) Esterification

The target functional group -COOR (where R represents a substituted or unsubstituted hydrocarbon group and a preferable R is such as that described above) can be introduced by adding an alcohol to the obtained carbon nanotube carboxylic acid and dehydrating the mixture for esterification.

The alcohol used for the esterification is determined according to R in the formula of the functional group. That is, if R is CH₃, the alcohol is methanol, and if R is C₂H₅, the alcohol is ethanol.

A catalyst is generally used in the esterification, and a conventionally known catalyst such as sulfuric acid, hydrochloric acid, or toluenesulfonic acid can be used in the present invention. The use of sulfuric acid as a catalyst is preferable from the viewpoint of not prompting a side reaction in the present invention.

The esterification may be conducted by adding an alcohol and a catalyst to carbon nanotube carboxylic acid and refluxing the mixture at an appropriate temperature for an appropriate time period. A temperature condition and a time period condition in this case depend on type of catalyst, type of alcohol, or the like and cannot be determined uniquely, but a reflux temperature is preferably close to the boiling point of the alcohol used. The reflux temperature is preferably in the range of 60°C to 70°C for methanol, for example. Further, a reflux time period is preferably in the range of 1 to 20 hours, more preferably in the range of 4 to 6 hours.

A carbon nanotube with the functional group -COOR (where R represents a substituted or unsubstituted hydrocarbon group and a preferable R is such as that described above) added can be obtained by separating a reaction product from a reaction solution after esterification and washing the reaction product as required.

### (Mixing Step)

The mixing step is a step of mixing, as required, carbon nanotubes having functional groups with a cross-linking agent prompting a cross-linking reaction with the functional groups or an additive for bonding the functional groups, to thereby prepare the cross-linking solution. In the mixing step, other components described in the aforementioned section titled (Other Additive) are mixed, in addition to the carbon nanotubes having functional groups and the cross-linking agent. Then, an amount of a solvent or a viscosity modifier is preferably adjusted considering application suitability, to thereby prepare the cross-linking solution just before supply (application) to the base body.

Simple stirring with a spatula and stirring with a stirrer of a stirring blade type, a magnetic stirrer, and a stirring pump may be only used. However, to achieve higher degree of uniformity in dispersion of the carbon nanotubes to enhance storage stability while fully extending a network structure by cross-linking of the carbon nanotubes, an ultrasonic disperser or a homogenizer may be used for powerful dispersion. However, the use of a stirring device with a strong shear force of stirring such as a homogenizer may cut or damage the carbon nanotubes in the solution, thus the device may be used for a very short period of time.

A carbon nanotube structure is formed by supplying (applying) the base body surface with the cross-linking solution described above and curing the cross-linking solution. A supplying method and a curing method are described in detail in the section below titled [Method of Manufacturing Rectifying Device].

The carbon nanotube structure in the present invention is in a state in which carbon nanotubes are networked. In detail, the carbon nanotube structure is cured into a matrix form in which carbon nanotubes are connected to each other through cross-linked sites, thereby sufficiently exerting the characteristics of a carbon nanotube itself such as high electron- and hole-transmission characteristics. In other words, the carbon nanotube structure has carbon nanotubes that are tightly connected to each other, contains no other binders and the like, and is thus composed substantially only of carbon nanotubes, so that characteristics peculiar to a carbon nanotube are used fully.

The thickness of the carbon nanotube structure of the present invention can be widely selected from being very thin to being thick according to the use. Lowering a content of the carbon nanotubes in the cross-linking solution used (simply, lowering the viscosity by diluting) and applying the cross-linking solution as a thin film provide a very thin coat. Similarly, raising a content of the carbon nanotubes may provide a thick coat. Further, repeating the application provides an even thicker coat. A very thin coat from a thickness of about 10 nm can be adequately formed, and a thick coat without an upper limit can be formed through recoating. A possible film thickness with one coating is about 5 µm. Further, a coat may have a desired shape by pouring the cross-linking solution having a content or the like adjusted into a mold and cross-linking the solution.

In the carrier transporter composed of the carbon nanotube structure formed according to the first method, a site where the carbon nanotubes mutually cross-link, that is, the cross-linked site formed through a cross-linking reaction between the functional groups of the carbon nanotubes and the cross-linking agent has a cross-linking structure. In the cross-linking structure, residues of the functional groups remaining after the cross-linking reaction are connected together with a connecting group, which is a residue of the cross-linking agent remaining after the cross-linking reaction.

As described, the cross-linking agent, which is a component of the cross-linking solution, is preferably non-self-polymerizable. A non-self-polymerizable cross-linking agent provides the connecting group in the finally formed carbon nanotube structure constructed from a residue of only one cross-linking agent. The gap between the carbon nanotubes to be cross-linked can be controlled to the size of a residue of the cross-linking agent used, thereby providing a desired network structure of the carbon nanotubes with high duplicability. Further, multiple cross-linking agents are not present between the carbon nanotubes, thus enabling enhancement of the actual density of the carbon nanotubes in the carbon nanotube structure. Further, reducing the size of a residue of the cross-linking agent can extremely narrow a gap between the carbon nanotubes both electrically and physically (carbon nanotubes are substantially in direct contact with each other).

Formation of the carbon nanotube structure with a cross-linking solution prepared by selecting a single functional group of the carbon nanotubes and a single non-self-polymerizable cross-linking agent results in the cross-linked site of the layer having an identical cross-linking structure (Example 1). Further, formation of the carbon nanotube structure with a cross-linking solution prepared by selecting even multiple types of functional groups of the carbon nanotubes and/or multiple types of non-self-polymerizable cross-linking agents results in the cross-linked sites of the layer mainly having a cross-linking structure based on a combination of the functional group and the non-self-polymerizable cross-linking agent mainly used (Example 2).

In contrast, formation of the carbon nanotube structure with a cross-linking solution prepared by selecting self-polymerizable cross-linking agents, without regard to whether the functional groups of the carbon nanotubes and the cross-linking agents are of single or multiple types, results in the cross-linked sites in the layer where carbon nanotubes are cross-linked together without a main, specific cross-linking structure. This is because the cross-linked sites will be in a state where numerous connecting groups with different connecting (polymerization) numbers of the cross-linking agents coexist.

In other words, by selecting non-self-polymerizable cross-linking agents, the cross-linked sites, where the carbon nanotubes of the carbon nanotube structure cross-link together, have a mainly identical cross-linking structure because a residue of only one cross-linking agent bonds with the functional groups. "Mainly identical" here is a concept including a case where all of the cross-linked sites have an identical cross-linking structure as described above (Example 1), as well as a case where the cross-linking structure based on a combination of the functional group and the non-self-polymerizable cross-linking agent mainly used becomes a main structure with respect to the total cross-linked sites as described above (Example 2).

When referring to "mainly identical", a "ratio of identical cross-linked sites" with respect to the total cross-linked sites will not have a uniform lower limit defined. The reason is that a case of giving a functional group with functionality or a cross-linking structure with an aim different from formation of a carbon nanotube network may be assumed, for example. However, in order to realize high electrical or physical characteristics peculiar to carbon nanotubes with a strong network, a "ratio of identical cross-linked sites" with respect to the total cross-linked sites is preferably 50% or more, more preferably 70% or more, further more preferably 90% or more, and most preferably 100%, based on numbers. Those number ratios can be determined through, for example, a method of measuring an intensity ratio of an absorption spectrum corresponding to the cross-linking structure with an infrared spectrum.

As described, a carbon nanotube structure having the cross-linked site with a mainly identical cross-linking structure where carbon nanotubes cross-link together allows formation of a uniform network of the carbon nanotubes in a desired state. In addition, the carbon nanotube network can be constructed with homogeneous, satisfactory, and expected electrical or physical characteristics and high duplicability.

Further, the connecting group preferably contains hydrocarbon as a skeleton thereof. "Hydrocarbon as a skeleton" here refers to a main chain portion of the connecting group consisting of hydrocarbon, the main portion of the connecting group contributing to connecting together residues of the functional groups of carbon nanotubes to be cross-linked remaining after a cross-linking reaction. A side chain portion, where hydrogen of the main chain portion is substituted by another substituent, is not considered. Obviously, it is more preferable that the whole connecting group consist of hydrocarbon.

The hydrocarbon preferably has 2 to 10 carbon atoms, more preferably 2 to 5 carbon atoms, and further more preferably 2 to 3 carbon atoms. The connecting group is not particularly limited as long as the connecting group is divalent or more.

In the cross-linking reaction of the functional group -COOR (where R represents a substituted or unsubstituted hydrocarbon group, and a preferable R is such as that described above) and ethylene glycol, already exemplified as a preferable combination of the functional group of carbon nanotubes and the cross-linking agent, the cross-linked site where multiple carbon nanotubes mutually cross-link becomes -COO(CH₂)₂OCO-.

Further, in the cross-linking reaction of the functional group -COOR (where R represents a substituted or unsubstituted hydrocarbon group, and a preferable R is such as that described above) and glycerin, the cross-linked site where multiple carbon nanotubes mutually cross-link becomes -COOCH₂CHOHCH₂OCO- or -COOCH₂CH(OCO-) CH₂OH if two OH groups contribute to the cross-linking, and the cross-linked site becomes -COOCH₂CH(OCO-)CH₂OCO- if three OH groups contribute to the cross-linking.

As has been described, the carrier transporter of the present invention in the case where the carbon nanotube structure is formed through the first method has a network structure composed of multiple carbon nanotubes connected to each other through multiple cross-linked sites. Thus, contact or arrangement of carbon nanotubes remains stable, unlike a mere carbon nanotube dispersion film. Therefore, the carrier transporter structure stably exerts characteristics peculiar to carbon nanotubes including: high carrier (electron or hole)-transmission characteristics; and physical characteristics such as thermal conductivity and toughness.

On the other hand, in forming the carbon nanotube structure through the second method, a site where the multiple carbon nanotubes mutually cross-link, that is, a cross-linked site formed by a cross-linking reaction among the functional groups of the multiple carbon nanotubes has a cross-linking structure in which residues of the functional groups remaining after a cross-linking reaction are connected to each other. In this case as well, the carbon nanotube structure has carbon nanotubes connected to each other through a cross-linked site in a matrix form, thereby easily exerting the characteristics of carbon nanotubes itself such as high electron- and hole- transmission characteristics. That is, the carrier transporter formed by the carbon nanotube structure formed according to the second method has the cross-linked sites formed through reacting the functional groups with each other, thus enabling enhancement of the actual density of the carbon nanotubes of the carbon nanotube structure. Further, reducing the size of a functional group can extremely narrow a gap between the carbon nanotubes both electrically and physically, thereby easily exerting the characteristics of a single carbon nanotube.

Since the cross-linked sites where the carbon nanotubes of the carbon nanotube structure cross-link together are formed by chemical bonding of the functional groups, the structure has a mainly identical cross-linking structure. "Mainly identical" here is a concept including a case where all of the cross-linked sites have an identical cross-linking structure as well as a case where the cross-linking structure formed by chemical bonding of the functional groups becomes a main structure with respect to the total cross-linked sites.

Accordingly, a carbon nanotube structure in which cross-linked sites where carbon nanotubes mutually cross-link have a mainly identical cross-linking structure can provide a carrier transporter having homogeneous electrical characteristics.

As has been described, the rectifying device in a particularly preferred mode of the present invention is formed in a state where the carbon nanotube structure has a network structure that is composed of multiple carbon nanotubes connected to each other through multiple cross-linked sites. Thus, contact or arrangement of carbon nanotubes is not disturbed, unlike a mere carbon nanotube dispersion film. Therefore, there are stably obtained characteristics that are unique of carbon nanotubes, including: electrical characteristics such as high electron- and hole-transmission characteristics; physical characteristics such as thermal conductivity and toughness; and light absorption characteristics. In addition, carrier transporters with a wide variety of constitutions can be obtained because the degree of freedom of the pattern of the carbon nanotube structure is also high.

The rectifying device of the present invention may have a layer other than a layer composed of the carbon nanotube structure (a layer of a carrier transporter).

For example, it is preferable to place an adhesive layer between the surface of the base body and the carbon nanotube structure for increasing the adhesiveness between them because the adhesive strength of the patterned carbon nanotube structure can be increased. The periphery of the carbon nanotube structure may also be coated with an insulator, a conductor, or the like depending on the use of the rectifying device.

Furthermore, a protective layer or any one of other various functional layers can be placed as an upper layer on the patterned carbon nanotube structure. When the protective layer is placed as the upper layer of the carbon nanotube structure, the carbon nanotube structure as a network of cross-linked carbon nanotubes can be more strongly held on the surface of the base body, and can be protected from an external force. A resist layer to be described in the section [Method of Manufacturing Rectifying Device] can be used without removal as the protective layer. Of course, a protective layer for covering the entire surface including a region other than a pattern corresponding to the carrier transporter can be newly provided. Any one of conventionally known various resin materials and inorganic materials can be used as a material constituting such a protective layer without any problem depending on purposes.

Furthermore, the carbon nanotube structures can be laminated through some type of functional layer. An insulating layer is formed as the functional layer, an appropriate pattern is employed for each of the carbon nanotube structures, and the carbon nanotube structures are appropriately connected to each other between layers, whereby a highly integrated device can be fabricated. Connection between layers at this time may be performed by separately providing a carbon nanotube structure, by using another carbon nanotube itself for wiring, or by any one of completely different methods such as the use of a metal film.

Inaddition, as described above, the base bodymay be a substrate having plasticity or flexibility. When the base body is a substrate having plasticity or flexibility, the flexibility of the entire carrier transporter increases, and the degree of freedom in use environments such as an installation location remarkably increases.

In addition, in the case where a rectifying device using such a substrate having plasticity or flexibility is used to constitute a device, the substrate can be used as a carrier transporter in a rectifying device having high mountability because it conforms to various arrangements and shapes in the device.

The specific shape and the like of the rectifying device of the present invention described above will be revealed in the next section titled [Method of Manufacturing Rectifying Device] and the section Examples. Of course,the constitutionsto be described later are merely illustrations, and specific modes of the rectifying device of the present invention are not limited to them.

### [Method of Manufacturing Rectifying Device]

The method of manufacturing a rectifying device of the present invention is a method suitable for manufacturing the rectifying device of the present invention described above. Further descriptions for an approach to arranging a single carbon nanotube on a substrate and an approach to forming a network structure through entanglement of carbon nanotubes by applying a mixed solution into which the carbon nanotubes are dispersed at high concentration are omitted. The following description is given of a more preferred embodiment, that is, the case where a carbon nanotube structure having a network structure formed via cross-linked sites is used as a carrier transporter.

This approach specifically includes: (A) a supplying step of supplying the surface of a base body with a solution containing multiple carbon nanotubes (cross-linking solution); (B) a cross-linking step of mutually cross-linking the multiple carbon nanotubes used as a carrier transporter to construct a network structure through curing of the solution after the application to thereby form a carbon nanotube structure having the network structure; and a step of forming an electrode before or after the steps (A) and (B) depending on the structure of a rectifying device to be manufactured.

In addition, other steps such as (C) a patterning step of patterning the carbon nanotube structure into a pattern corresponding to a carrier transporter may be added.

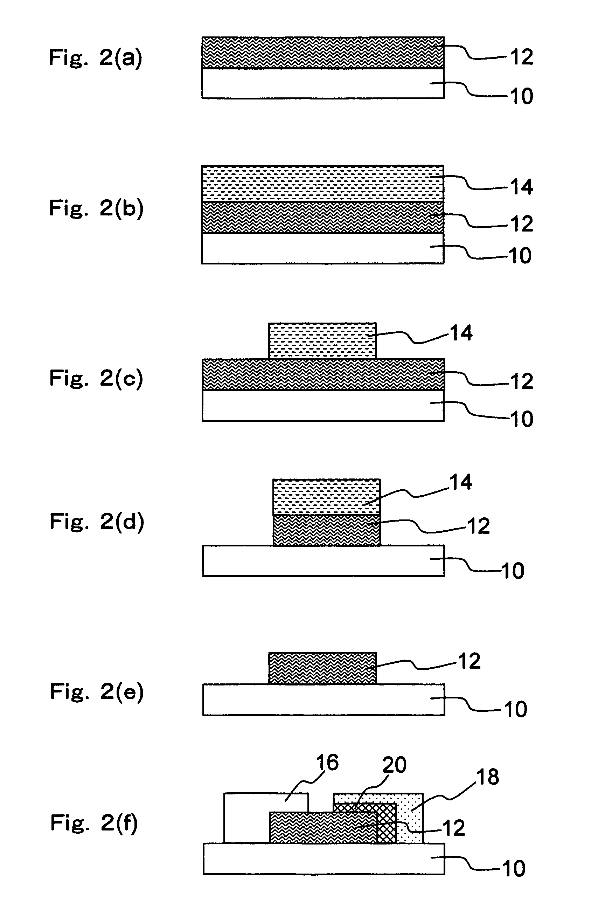

Hereinafter, each step of the method of manufacturing a rectifying device of the present invention will be described in detail with reference to Figs. 2.

Here, Figs. 2 are schematic sectional diagrams of the surface of the base body during the manufacturing process for explaining an example ((C-A-2) to be described below) of the method of manufacturing a rectifying device of the present invention. In the figures, reference numeral 10 denotes a substrate-like base body; 16 and 18, electrodes; 12, a carbon nanotube structure; and 14, a resist layer.

### (A) Supplying Step

In the present invention, the "supplying step" is a step of arranging a carbon nanotube constituting a carrier transporter on the surface of the base body. Here, a description is given of, in particular, the case where a carbon nanotube structure having a network structure formed via cross-linked sites is used.

In this case, the supplying step is a step of supplying (applying) a solution (cross-linking solution) containing multiple carbon nanotubes having functional groups and a cross-linking agent which prompts a cross-linking reaction with the functional groups. A region to which the cross-linking solution is to be supplied in the supplying step has only to include the desired region in whole, and it is not necessary to apply the solution to the entire surface of the base body.

The supplying method, which is preferably application of the cross-linking solution, is not particularly limited, and any method can be adopted from a wide range. For example, the solution may be simply dropped or spread with a squeegee or may be applied by a common application method. Examples of common application methods include spin coating, wire bar coating, cast coating, roll coating, brush coating, dip coating, spray coating, and curtain coating.

The contents of the base body, the carbon nanotubes having functional groups, the cross-linking agent, and the cross-linking solution are as described in the section titled [Rectifying Device] .

### (B) Cross-linking Step

In the present invention, the "cross-linking step" is a step of chemically bonding the functional groups of the multiple carbon nanotubes in the cross-linking solution after the supply to form cross-linking sites, to thereby form the carbon nanotube structure. In the case where the supplying step involves the application of the cross-linking solution, the cross-linking step is a step of mutually cross-linking the multiple carbon nanotubes to construct a network structure through curing of the cross-linking solution after the application to thereby form a structure layer having the network structure. A region where the carbon nanotube structure is to be formed by curing the cross-linking solution in the cross-linking step has only to include the desired region in whole, and it is not necessary to cure the entirety of the cross-linking solution applied to the surface of the base body.

An operation carried out in the cross-linking step is naturally determined according to the combination of the functional groups and the cross-linking agent, for example, as shown in Table 1 above. A combination of thermosetting functional groups and cross-linking agent employs heating the cross-linking solution with various heaters or the like. A combination of functional groups and a cross-linking agent that are cured by UV rays employs irradiating the cross-linking solution with a UV lamp or leaving the cross-linking solution under the sun. A combination of air setting functional groups and cross-linking agent only employs letting the cross-linking solution stand still. "Letting the cross-linking solution stand still" is deemed as one of the operations that may be carried out in the cross-linking step of the present invention.

Heat curing (polyesterification through an ester exchange reaction) is conducted for the case of a combination of a carbon nanotube, to which the functional group -COOR (where R represents a substituted or unsubstituted hydrocarbon group and a preferable R is such as that described above) is added, and a polyol (among them, glycerin and/or ethylene glycol). Heating causes an ester exchange reaction between -COOR of the esterified carbon nanotube carboxylic acid and R'-OH (where R' represents a substituted or unsubstituted hydrocarbon group, and is preferably selected from -CₙH₂ₙ₋₁, -CₙH₂ₙ, and -CₙH₂ₙ₊₁ (where n represents an integer of 1 to 10) each of which may be substituted) of the polyol. As the reaction progresses multilaterally, the carbon nanotubes are cross-linked until a network of carbon nanotubes connected to each other constructs a carbon nanotube structure.

To give an example of conditions preferable for the above combination, the heating temperature is specifically set to preferably 50°C to 500°C, or more preferably 120°C to 200°C. The heating time period for the above combination is specifically set to preferably 1 minute to 10 hours, or more preferably 1 to 2 hours.

Fig. 2(a) shows a state where the carbon nanotube structure 12 is formed on the surface of the base body 10 through (B) Cross-linking Step.

### (C) Patterning Step

In the present invention, the "patterning step" is a step of patterning the carbon nanotube structure into a pattern corresponding to a carrier transporter. Fig. 2(e) is a schematic sectional diagram showing a state of the surface of the base body after (C) Patterning Step.

Although no particular limitations are put on operations of the patterning step, there are two preferred modes of (C-A) and (C-B) to the patterning step.

### (C-A)

A mode in which dry etching is performed on the carbon nanotube structure in a region of the surface of the base body other than the region having the pattern corresponding to the carrier transporter, thus removing the carbon nanotube structure from the region and patterning the carbon nanotube structure into the pattern corresponding to the carrier transporter.

Patterning the carbon nanotube structure into a pattern corresponding to the carrier transporter by dry etching means that the carbon nanotube structure in a region of the surface of the base body other than the region having the pattern is irradiated with radicals or the like. Methods of irradiation with radicals or the like include one in which the carbon nanotube structure in a region other than a region having the pattern is directly irradiated with radicals or the like (C-A-1), and one in which the region other than a region having the pattern is covered with a resist layer and then the entire surface of the base body (of course, on the side where the carbon nanotube structure and the resist layer are formed) is irradiated with radicals or the like (C-A-2).

### (C-A-1)

Direct irradiation of the carbon nanotube structure in a region other than a region having the pattern with radicals or the like specifically means that the patterning step includes: selectively irradiating the carbon nanotube structure in a region of the surface of the base body other than the region having the pattern corresponding to the carrier transporter with ion beams of gas molecule ions, thereby removing the carbon nanotube structure from the irradiated region; and patterning the carbon nanotube structure into a pattern corresponding to the carrier transporter.

In the form of an ion beam, ions of gas molecules can be radiated selectively with precision on the order of several nm. This method is preferable in that the carbon nanotube structure can be patterned into a pattern corresponding to a carrier transporter in one operation.

Examples of gas species that can be chosen include oxygen, argon, nitrogen, carbon dioxide, and sulfur hexafluoride. Oxygen is particularly preferable in the present invention.

In the ion beam method, a voltage is applied to gas molecules in vacuum to accelerate and ionize the gas molecules and the obtained ions are radiated in the form of a beam. Substances to be etched and irradiation accuracy can be changed by changing the type of gas used.

### (C-A-2)

In the mode in which the regions other than the region having the pattern are covered with a resist layer before the entire surface of the base body is irradiated with radicals or the like, the patterning step specifically includes:
a resist layer forming step (C-A-2-1) of forming a resist layer above the carbon nanotube structure in a region on the surface of the base body having the pattern corresponding to the carrier transporter; and
a removing step (C-A-2-2) of removing the carbon nanotube structure exposed in a region other than the region by subjecting a surface of the base body on which the carbon nanotube structure and the resist layer are laminated to dry etching. The patterning step may include:
a resist layer peeling-off step (C-A-2-3) of peeling off the resist layer formed in the resist layer forming step subsequent to the removing step.

### (C-A-2-1) Resist Layer Forming Step

In the resist layer forming step, a resist layer is formed above the carbon nanotube structure in a region on the surface of the base body having the pattern corresponding to the carrier transporter. This step follows a process generally called a photolithography process and, instead of directly forming a resist layer above the carbon nanotube structure in a region having the pattern corresponding to the carrier transporter, a resist layer 14 is once formed on the entire surface of the base body 10 on which the carbon nanotube structure 12 is formed as shown in Fig. 2(b). Then, the region having the pattern corresponding to the carrier transporter is exposed to light and portions that are not exposed to light are removed through subsequent development. Ultimately, the resist layer is present on the carbon nanotube structure in the region having the pattern corresponding to the carrier transporter.

Fig. 2(c) is a schematic sectional diagram showing a state of the surface of the base body after (C-A-2-1) resist layer forming step. Depending on the type of resist, a portion that is exposed to light is removed by development whereas a portion that is not exposed to light remains.

A known method can be employed to form the resist layer. Specifically, the resist layer is formed by applying a resist agent to the substrate with a spin coater or the like and then heating the applied agent.

There is no particular limitation on the material (resist agent) used to form the resist layer 14, and various known resist materials can be employed without any modification. Employing a resin (forming a resin layer) is particularlypreferable. The carbon nanotube structure 12 has a mesh-like network of carbon nanotubes and is of a porous structure. Accordingly, if the resist layer 14 is formed from a metal evaporation film or like other material that forms a film on the very surface and does not infiltrate deep into the holes of the mesh, carbon nanotubes cannot be sealed satisfactorily against radiation of plasma or the like (insufficient sealing means exposure to plasma or the like) . As a result, plasma or the like enters from the holes and corrodes the carbon nanotube structure 12 under the resist layer 14, reducing the contour of the carbon nanotube structure 12 and leaving only a small portion of the carbon nanotube structure 12 due to diffraction of plasma or the like. Although it is possible to give the resist layer 14 a larger contour (area) than the pattern corresponding to the carrier transporter taking into account this reduction in size, this method requires a wide gap between patterns and therefore makes it impossible to form patterns close together.

In contrast, when a resin material is used to form the resist layer 14, the resin enters the spaces inside the holes and reduces the number of carbon nanotubes that are exposed to plasma or the like. As a result, the carbon nanotube structure 12 can be patterned at high density.

Examples of the resin material that mainly constitutes the resin layer include, but not limited to, a novolac resin, polymethyl methacrylate, and a mixture of these resins.

The resist material for forming the resist layer is a mixture of one of the above resin materials, or a precursor thereof, and a photosensitive material or the like. The present invention can employ any known resist material. For instance, an OFPR 800 manufactured by TOKYO OHKA KOGYO CO. , LTD. and an NPR 9710 manufactured by NAGASE & CO., LTD. can be employed.

Appropriate operations or conditions to expose the resist layer 14 to light (heating if the resist material used is thermally curable, a different exposure method is chosen for a different type of resist material) and to develop are selected in accordance with the resist material used. (Examples of exposure and development operations or conditions include the light source wavelength, the intensity of exposure light, the exposure time, the exposure value, environmental conditions during exposure, the development method, the type and concentration of developer, the development time, the development temperature, and what pre-treatment or post-treatment is to be employed.) When a commercially available resist material is used, the instruction manual for the resist material should be followed. In general, for conveniences of handling, the layer is exposed to ultraviolet rays to draw the pattern corresponding to the carrier transporter. After that, the film is developed using an alkaline developer, which is then washed off with water, and is let dry to complete the photolithography process.

### (C-A-2-2) Removing Step

In the removing step, dry etching is performed on a surface of the base body on which the carbon nanotube structure and the resist layer are laminated, thereby removing the carbon nanotube structure exposed in a region other than the region. (See Fig. 2 (c) . The carbon nanotube structure 12 is exposed in a portion from which the resist layer 14 is removed) . Fig. 2 (d) is a schematic sectional diagram showing a state of the surface of the base body after (C-A-2-2) removing step.

The removing step can employ every method that is generally called dry etching, including the reactive ion method. The above-described ion beam method in (C-A-1) is one of the dry etching methods.

See the section (C-A-1) for employable gas species, devices, operation environments, and the like.

In the present invention, oxygen is particularly preferable out of examples of gas species generally usable in dry etching which include oxygen, argon, and fluorine-based gas (e.g., chlorofluoro carbon, SF₆, and CF₄). With oxygen radicals, carbon nanotubes in the carbon nanotube structure 12 to be removed are oxidized (burnt) and turned into carbon dioxide. Accordingly, the residue has little adverse effect, and accurate patterning is achieved.

When oxygen is chosen as gas species, oxygen radicals are generated by irradiating oxygen molecules with ultraviolet rays and are used. A device that generates oxygen radicals by means of this method is commercially available by the name of UV washer, and is easy to obtain.

### (C-A-2-3) Resist Layer Peeling-off Step

The manufacture of a rectifying device may involve the formation of a carrier transporter on the base body on which an electrode pair has been formed in advance, and may end with the completion of (C-A-2-2) removing step. If the resist layer 14 is to be removed, the removing step has to be followed by a resist layer peeling-off step of peeling off the resist layer 14 formed in the resist layer forming step. Fig. 2 (e) is a schematic sectional diagram showing a state of the surface of the base body after (C-A-2-3) resist layer peeling-off step.

An appropriate operation for the resist layer peeling-off step is chosen in accordance with the material used to form the resist layer 14. When a commercially available resist material is used, the resist layer 14 is peeled off following the instruction manual for the resist material. When the resist layer 14 is a resin layer, a common removal method is to bring the resin layer into contact with an organic solvent that is capable of dissolving the resin layer.

### (C-B)

A mode in which the patterning step includes:
a resist layer forming step of forming a resist layer above the carbon nanotube structure in a region on the surface of the base body having the pattern corresponding to the carrier transporter; and
a removing step of removing the carbon nanotube structure exposed in a region other than the region by bringing a surface of the base body on which the carbon nanotube structure and the resist layer are laminated into contact with an etchant.

The mode is a method commonly called wet etching (a method of removing an arbitrary portion using chemical = etchant).

Details about the resist layer forming step here is identical with (C-A-2-1) resist layer forming step described above except that a resist material having resistance to the etchant is desirably used. The removing step here may be followed by the resist layer peeling-off step, and details of this peeling-off step are as described in (C-A-2-3) resist layer peeling-off step. Detailed descriptions of those steps are therefore omitted here.

Reference is made to Fig. 2(c). In the removing step, an etchant is brought into contact with the surface of the base body 12 on which the carbon nanotube structure 12 and the resist layer 14 are laminated, thereby removing the carbon nanotube structure 12 exposed in a region other than the region.

In the present invention, "bringing an etchant into contact with" is a concept including all operations for bringing a liquid into contact with a subject, and a liquid may be brought into contact with a subject by any methods such as dipping, spraying, and letting a liquid flow over a subject.

The etchant is in general an acid or alkali. Which etchant to choose is determined by the resist material constituting the resist layer 14, the cross-linking structure among carbon nanotubes in the carbon nanotube structure 12, and other factors. A desirable etchant is one that etches the resist layer 14 as little as possible and that can easily remove the carbon nanotube structure 12.

However, an etchant that etches the resist layer 14 may be employed if it is possible to, by appropriately controlling the temperature and concentration of the etchant and how long the etchant is in contact with the carbon nanotube structure, remove the exposed carbon nanotube structure 12 before the resist layer 14 is completely etched away.

### (D) Electrode Forming Step

In the present invention, the term "electrode forming step" refers to a step of forming an electrode pair on the carbon nanotube structure 12 after the patterning step as a preceding step. Any one of conventionally known processes such as a thin film process and a thick film process can be appropriately used as a method of forming an electrode; provided, however, that the electrode forming step may be replaced with another step depending on a device structure as described below.

### (E) Barrier Layer Forming Step

This step is performed before, after, or simultaneously with (D) electrode forming step depending on an approach to making the first connection configuration and the second connection configuration between the other electrode and the carrier transporter different.

This step can be interpreted as an example of the "connection configuration forming step" as used herein.

Hereinafter, an embodiment of the barrier forming step will be described. However, the present invention is not limited thereto.

### (E-1)

When barrier levels can be made different by making materials for the first electrode and the second electrode different, the electrode forming step and the barrier layer forming step are performed simultaneously.

### (E-2)

When the oxide layer is formed at the first interface, a step of forming the oxide layer at the first interface is needed. Examples of a method of forming the oxide layer include a method of forming an oxide directly by means of a conventionally known thin film process or the like and a method involving oxidizing the interface at which the first electrode formed of an oxidative material and the carrier transporter are opposed to each other to form the oxide layer. A metal having strong oxidation resistance such as gold, or a metal having oxidation property different from that of the metal for the first electrode is used for the second electrode, whereby the first interface and the second interface can have different barrier levels.

The oxide film is preferably formed through natural oxidation of an electrode metal in an atmosphere containing oxygen in order to make the oxide film compact and thin, but may be formed through, for example, deposition of an oxide or thermal oxidation.

### (E-3)

When the first interface and the second interface are allowed to have different barrier levels by processing the surface of the carrier transporter to reduce or increase the degree of adhesion between the surface and the electrode, a step of processing the surface of the carrier transporter must be performed prior to the electrode forming step.

Multiple of the above specific examples of the formation of a barrier layer may be combined.

When at least one electrode is arranged on the surface of the substrate prior to the formation of the carrier transporter, and the carrier transporter is formed on the electrode, the barrier layer forming step may be performed before, after, or simultaneously with the steps (A) to (C) of forming the carrier transporter.

Fig. 2 (f) is a schematic sectional diagram showing a rectifying device to be finally obtained through the above manufacturing method. Reference numerals 16 and 18 denote electrodes. The electrode 18 ("one electrode" as used herein) is connected to the carbon nanotube structure 12 via a barrier layer (oxide layer) 20. The electrode 16 ("other electrode" as used herein) is directly connected to the carbon nanotube structure 12.

### (F) Other Steps

The rectifying device of the present invention can be manufactured through the above steps. However, the method of manufacturing a rectifying device of the present invention may include additional steps.

For instance, it is preferable to put a surface treatment step for pre-treatment of the surface of the base body before the supplying step. The purpose of the surface treatment step is, for example, to enhance the absorption of the cross-linking solution to be applied, to enhance the adhesion between the surface of the base body and the carbon nanotube structure to be formed thereon as an upper layer, to clean the surface of the base body, or to adjust the electric conductivity of the surface of the base body.

An example of the surface treatment step for enhancing the absorption of the cross-linking solution is treatment with a silane coupling agent (e.g., aminopropyltriethoxysilane or γ-(2-aminoethyl)aminopropyltrimethoxysilane). Surface treatment with aminopropyltriethoxysilane is particularly widely employed and is preferable for the surface treatment step in the present invention. As documented by Y. L. Lyubchenko et al. in "Nucleic Acids Research vol. 21 (1993)" on pages 1117 to 1123, for example, surface treatment with aminopropyltriethoxysilane has conventionally been employed to treat the surface of a mica substrate for use in observation of AFM of DNA.

In particular, in the case where an oxidative metal material is used for an electrode in the present invention, at least a gap between a carrier transporter and the electrode is desirably sealed with oxygen. The sealing prevents the deterioration of properties with time. Of course, the sealing is not necessarily required when such deterioration of properties with time is actively used as a function like a sensor.

In the case where two or more layers of carbon nanotube structures themselves are to be laminated, the operation of the method of manufacturing a rectifying device of the present invention is repeated twice or more. If an intermediate layer such as a dielectric layer or an insulating layer is to be interposed between carbon nanotube structure layers, a step for forming the layer is inserted in between and then the operation of the method of manufacturing a rectifying device of the present invention is repeated.

In addition, in the case where other layers such as a protective layer and an electrode layer are separately laminated, a step for forming these layers is needed. Each of those layers may be appropriately formed by selecting the material and forming method for the layer depending on a purpose from conventionally known ones or by using a product or method newly developed for the present invention.

### <Applied Example of Method of Manufacturing Rectifying Device of the Present Invention>

In forming a carrier transporter on the surface of a base body, an applied example of the method of manufacturing a rectifying device of the present invention is a method involving: patterning the carbon nanotube structure on the surface of a temporary substrate; and transferring the patterned carbon nanotube structure onto a desired base body (transferring step). The transferring step may involve: transferring the patterned carbon nanotube structure from the temporary substrate to the surface of an intermediate transfer member; and transferring the carbon nanotube structure onto a desired base body (second base body). Hereinafter, a temporary substrate having a carbon nanotube structure transferred onto its surface may be referred to as a "carbon nanotube transfer member".

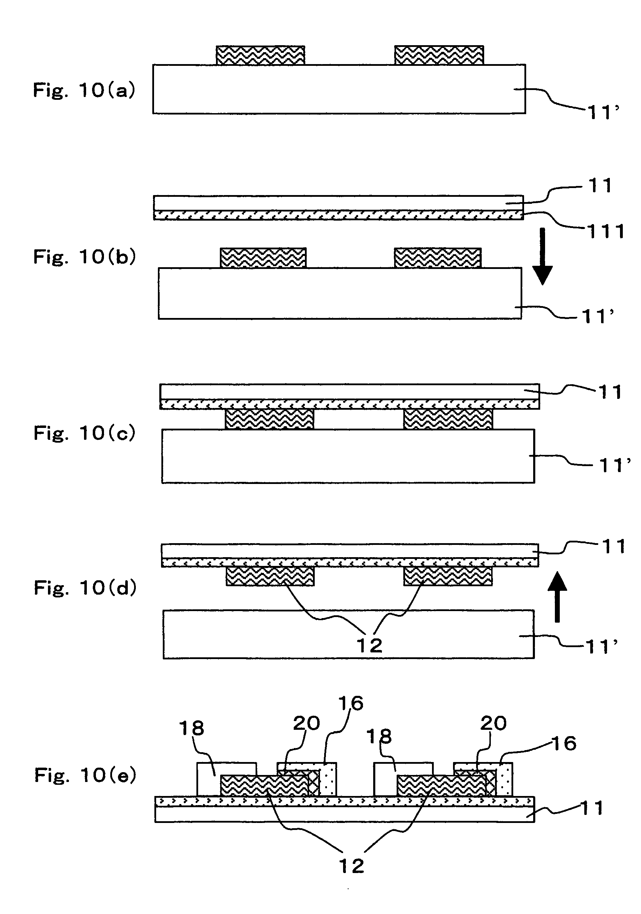

Hereinafter, a specific method will be described with reference to Figs. 10.

In the same manner as that described above, carbon nanotube structures are formed on the surface of a temporary substrate 11', and are patterned into shapes corresponding to transporting layers (carrier transporter) 12 (Fig. 10(a)). In this description, two transporting layers (carrier transporters) were simultaneously formed on the temporary substrate 11'.

Subsequently, a substrate (base body) 11 having an adhesive surface 111 formed on its surface is attached to the transporting layers 12 on the surface of the temporary substrate 11' (Figs. 10 (b) and (c)).

After that, the substrate 11 is peeled off from the temporary substrate 11', whereby the transporting layers 12 are transferred onto the adhesive surface 111 of the substrate 11 (Fig. 10(d)).

Next, oxide films 20, and electrodes 16 and 18 are laminated by means of sputtering or the like on the transporting layer 10 transferred onto the substrate 11.

Thus, two rectifying devices are simultaneously formed (Fig. 10(e)).

Those devices can be integrated by electrically connecting them with other devices through wiring.

The temporary substrate material that can be used in this applied example is preferably the same as the base body material described in the section titled [Rectifying Device]. However, a temporary substrate that has at least one flat surface, more desirably, one that is shaped like a flat plate is preferable in consideration of transfer suitability in the transferring step.

To be employable in the applied example, a base body or an intermediate transfer member has to have an adhesive surface holding, or capable of holding, an adhesive. Common tape such as cellophane tape, paper tape, cloth tape, or imide tape can be of course used in the applied example. In addition to the tape and other materials that have plasticity or flexibility, rigid materials may also be employed as a base body or an intermediate transfer member. In the case of a material that does not come with an adhesive, an adhesive is applied to a surface of the material that can hold an adhesive to cause the surface to serve as an adhesive surface, whereby the material can be used in a similar fashion to normal adhesive tape.

According to the applied example, the rectifying device of the present invention can be easily manufactured.

A rectifying device can also be manufactured by: preparing a base body carrying a carbon nanotube structure on its surface; and attaching the base body to the surface of a desired second base body (for example, a casing) constituting the device.

Alternatively, even when the user skips the cross-linking step, a carrier transporter of a rectifying device can be also manufactured by: using a carbon nanotube transfer member in which a carbon nanotube structure is carried on the surface of a temporary substrate (or intermediate transfer member) to transfer only the carbon nanotube structure onto the surface of a base body constituting the rectifying device; and removing the temporary substrate (or intermediate transfer member) . Here, the intermediate transfer member may serve as a temporary substrate of the carbon nanotube transfer member during the process. However, there is no need to distinguish the intermediate transfer member from the carbon nanotube transfer member itself, and hence the case is also included in the present invention.

The use of a carbon nanotube transfer member extremely simplifies the subsequent handling because a carbon nanotube structure in a cross-linked state is carried on the surface of a temporary substrate. Therefore, a rectifying device can be manufactured with extreme ease. A method of removing a temporary substrate can be appropriately selected from simple peeling, chemical decomposition, burnout, melting, sublimation, dissolution, and the like.

The applied example of the method of manufacturing a rectifying device is particularly effective in the case where a base body of a device has a material and/or shape that make it difficult to apply the method of manufacturing a rectifying device of the present invention without some changes.

For instance, the applied example of the present invention is effective in the case where the temperature at which the solution after the supply is cured in the cross-linking step is equal to or higher than the melting point or glass transition point of the material that is to be used as a base body of the rectifying device. In this case, the heating temperature is set lower than the melting point of the temporary substrate to ensure a heating temperature necessary for the curing, and thus the rectifying device of the present invention can be manufactured appropriately.

In addition, for example, when the patterning step involves: subjecting a carbon nanotube structure in a region on the surface of the temporary substrate other than the region having the pattern corresponding to the carrier transporter to dry etching to remove the carbon nanotube structure in the region; and patterning the carbon nanotube structure into the pattern corresponding to the carrier transporter, the applied example of the present invention is effective in the case where a material to be used as a base body of the rectifying device has no resistance to dry etching to be performed in the patterning step. At this time, a material having resistance to dry etching is used for the temporary substrate, whereby the resistance to the operation of the step of patterning onto the temporary substrate can be ensured, and the rectifying device of the present invention can be manufactured appropriately.

Although specifics on resistance and material vary depending on dry etching conditions including gas species, intensity, time, temperature, and pressure, resin materials have relatively low resistance to dry etching. When a resin material is used as the base body, limitations brought by low resistance of the resin material are lifted by employing this applied example. Therefore, forming the base body from a resin material is preferable in that merits of the applied example are brought out. On the other hand, each of inorganic materials, which have relatively high resistance to dry etching, is suitable for the temporary substrate. In general, plastic or flexible materials have low resistance to dry etching and therefore using one of such materials as the base body is preferable in that merits of this applied example are brought out.

To give another example, the applied example of the present invention is effective also in the case where the patterning step includes: a resist layer forming step of forming a resist layer above the carbon nanotube structure in a region on the surface of the temporary substrate having the pattern corresponding to the carrier transporter; and a removing step of removing the carbon nanotube structure exposed in a region other than the region by bringing a surface of the temporary substrate on which the carbon nanotube structure and the resist layer are laminated into contact with an etchant, and the base body has no resistance to the etchant used in the patterning step, but the temporary substrate has resistance to the etchant. In this case, the base body in this applied example serves as a base body of the rectifying device and a material having resistance to the etchant is used as the temporary substrate so that the resistance to the operation of the step of patterning onto the temporary substrate can be ensured. Thus, the rectifying device of the present invention can be manufactured appropriately.

Specifics on resistance and material vary depending on etching conditions including the type, concentration, and temperature of the etchant used, and how long the etchant is in contact with the carbon nanotube structure. When an acidic etchant is used and a base body of the rectifying device is to be formed from aluminum or like other materials that do not withstand acid, for example, limitations brought by low resistance of the base body material are lifted by employing the applied example and using silicon or other materials having resistance to acid as the temporary substrate. Limitations brought by low resistance are also lifted by using as the base body a material that has low resistance to an etchant as described above although depending on whether the etchant is acidic or alkaline.

As another mode, for making the rectifying device of the present invention easy to handle even more, a base body that carries the carbon nanotube structure 24 may be pasted onto a second base body to constitute the rectifying device of the present invention or an apparatus using the same. The second base body may be physically rigid or may be plastic or flexible, and can take various shapes including a spherical shape and a concave-convex shape.

### <More Specific Examples>

Hereinafter, the present invention will be described more specifically by way of examples. However, the present invention is not limited to the following examples.

### [Example 1]

In this example, a rectifying device using a glycerin-cross-linked film of single-wall carbon nanotubes having semiconductor properties as a carrier transporter was prepared according to the flow of the method of manufacturing a rectifying device shown in Figs. 2. Titanium and aluminum were used as electrode materials to form electrodes. Aluminum was naturally oxidized to form an oxide film at an electrode-carbon nanotube structure interface. Reference numerals shown in Figs. 2 may be used in the description of this example.

### (A) Supplying Step

### (A-1) Preparation of Cross-linking Solution (Addition Step)

### (i) Purification of Single-wall Carbon Nanotube

Single-wall carbon nanotube powder (purity: 40%, available from Sigma-Aldrich Co.) was sieved (pore size of 125 µm) in advance to remove a coarse aggregate. 30 mg of the resultant (having an average diameter of 1.5 nm and an average length of 2 µm) were heated at 450°C for 15 minutes by means of a muffle furnace to remove a carbon substance except a carbon nanotube. 15 mg of the remaining powder were immersed in 10 ml of a 5N aqueous solution of hydrochloric acid {prepared by diluting concentrated hydrochloric acid (a 35% aqueous solution, available from Kanto Kagaku) with pure water by 2-fold} for 4 hours to dissolve a catalyst metal.

The solution was filtered to recover a precipitate. The recovered precipitate was repeatedly subjected to the above step involving heating and immersion in hydrochloric acid three times for purification. At this time, conditions for heating were strengthened in a stepwise manner: 450°C for 20 minutes, 450°C for 30 minutes, and 550°C for 60 minutes.

The carbon nanotube after the purification is found to have a significantly increased purity as compared to that before the purification (raw material) (specifically, the purity is estimated to be 90% or higher). The purified carbon nanotube finally obtained had a mass (1 to 2 mg) about 5% of the raw material.

The above operation was repeated multiple times to purify 15 mg or more of high-purity single-wall carbon nanotube powder.

### (ii) Addition of Carboxyl Group ... Synthesis of Carbon Nanotube Carboxylic Acid

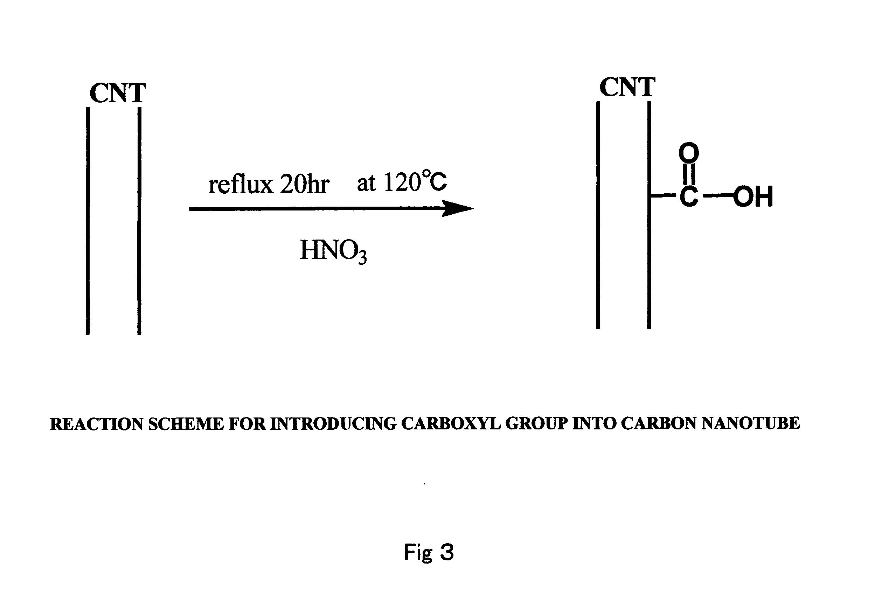

30 mg of single-wall carbon nanotube powder (purity: 90%, average diameter: 30 nm, average length: 3 µm, available from Science Laboratories, Inc.) were added to 20 ml of concentrated nitric acid (60 mass% aqueous solution, available from Kanto Kagaku) for reflux at 120°C for 5 hours, to synthesize a carbon nanotube carboxylic acid. A reaction scheme of the above is shown in Fig. 3. In Fig. 3, a carbon nanotube (CNT) portion is represented by two parallel lines (the same applies for other figures relating to reaction schemes).

The temperature of the solution was returned to room temperature, and the solution was centrifuged at 5,000 rpm for 15 minutes to separate a supernatant solution from a precipitate. The recovered precipitate was dispersed in 10 ml of pure water, and the dispersion solution was centrifuged again at 5,000 rpm for 15 minutes to separate a supernatant solution from a precipitate (the above process constitutes one washing operation). This washing operation was repeated five more times, and finally, a precipitate was recovered.

An infrared absorption spectrum of the recovered precipitate was measured. An infrared absorption spectrum of the used single-wall carbon nanotube raw material itself was also measured for comparison. A comparison between both the spectra revealed that absorption at 1,735 cm⁻¹ characteristic of a carboxylic acid, which was not observed in the single-wall carbon nanotube raw material itself, was observed in the precipitate. This finding shows that a carboxyl group was introduced into a carbon nanotube by the reaction with nitric acid. In other words, this finding confirmed that the precipitate was a carbon nanotube carboxylic acid.

Addition of the recovered precipitate to neutral pure water confirmed that dispersability was good. This result supports the result of the infrared absorption spectrum that a hydrophilic carboxyl group was introduced into a carbon nanotube.

### (iii) Esterification

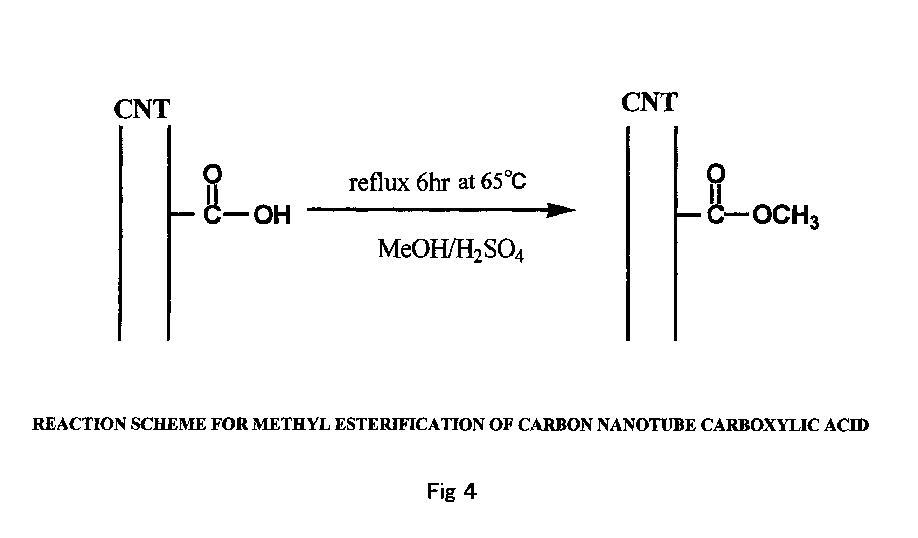

30 mg of the carbon nanotube carboxylic acid prepared in the above step were added to 25 ml of methanol (available from Wako Pure Chemical Industries, Ltd.). Then, 5ml of concentrated sulfuric acid (98 mass%, available from Wako Pure Chemical Industries, Ltd.) were added to the mixture, and the whole was refluxed at 65°C for 6 hours for methyl esterification. The reaction scheme is shown in Fig. 4.

After the temperature of the solution had been returned to room temperature, the solution was filtered to separate a precipitate. The precipitate was washed with water, and was then recovered. An infrared absorption spectrum of the recovered precipitate was measured. As a result, absorption at 1,735 cm⁻¹ and that in the range of 1,000 to 1, 300 cm⁻¹ characteristic of ester were observed. This result confirmed that the carbon nanotube carboxylic acid was esterified.

### (Mixing Step)

30 mg of the carbon nanotube carboxylic acid methyl esterified in the above step were added to 4 g of glycerin (available from Kanto Kagaku), and the whole was mixed using an ultrasonic disperser. Further, the mixture was added to 4 g of methanol as a viscosity modifier to prepare a cross-linking solution (1).

### (A-2) Surface Treatment Step of Base Body

Prepared was a silicon wafer (available from Advantech Co., Ltd, 76.2 mmΦ (diameter of 3 inches), thickness of 380 µm, thickness of a surface oxide film of 1 µm) as the base body 10. The silicon wafer was subjected to surface treatment using aminopropyltriethoxysilane for enhancing adsorption of the silicon wafer with respect to the cross-linking solution (1) to be applied to the wafer.

The silicon wafer was subjected to the surface treatment using aminopropyltriethoxysilane by exposing the silicon wafer to steam of 50 µl of amino propyltriethoxysilane (available from Sigma-Aldrich Co.) for about 3 hours in a closed Schale.

For comparison, a silicon wafer which had not been subjected to surface treatment was also separately prepared.

### (A-3) Supplying Step

The cross-linking solution (1 µl) prepared in Step (A-1) was applied to the surface of the silicon wafer (the base body 10) subjected to the surface treatment by using a spin coater (1H-DX2, manufactured by MIKASA Co., Ltd.) at 100 rpm for 30 seconds.

### (B) Cross-linking Step

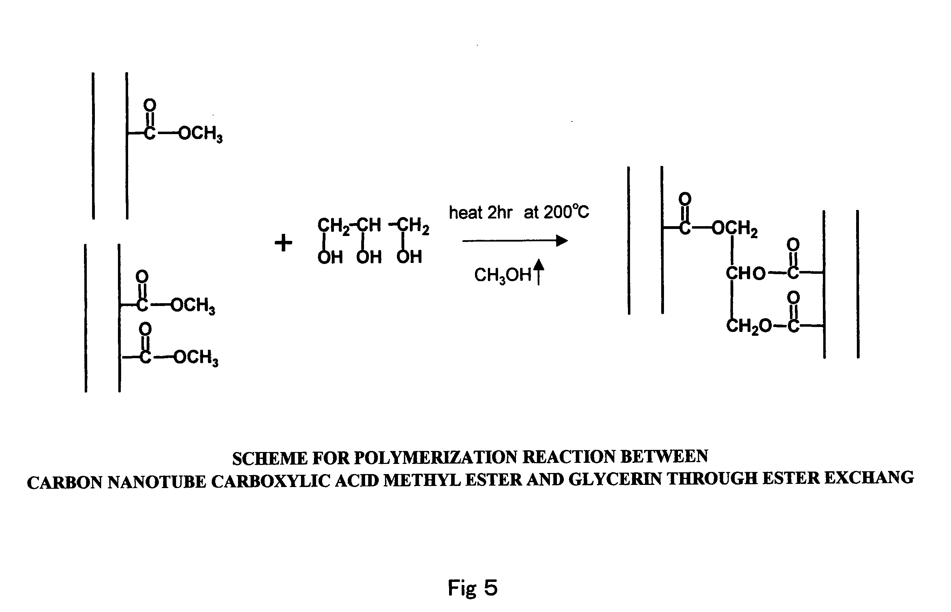

After the application of the cross-linking solution, the silicon wafer on which the coat had been formed (the base body 10) was heated at 200°C for 2 hours to cure the coat, thereby forming the carbon nanotube structure 12 (Fig. 2(a)). Fig. 5 shows the reaction scheme.

The observation of the state of the obtained carbon nanotube structure 12 by means of an optical microscope confirmed an extremely uniform cured film.

### (C) Patterning Step

### (C-1) Resist Layer Forming Step

A resist agent (available from Nagase & Co., LTD, NPR9710, viscosity of 50 mPa·s) was applied to the surface on the side of the carbon nanotube structure 12 of the silicon wafer 12 (subjected to surface treatment) on which the carbon nanotube structure 12 had been formed by using a spin coater (manufactured by Mikasa, 1H-DX2) at 2,000 rpm for 20 seconds. Then, the applied agent was heated on a hot plate at 100°C for 2 minutes to form a film, thereby forming the resist layer 14 (Fig. 2(b)).

The resist agent NPR9710 had the following composition.
- Propylene glycol monomethyl ether acetate: 50 to 80 mass%
- Novolac resin: 20 to 50 mass%
- Photosensitive agent: less than 10 mass%

The surface on the side of the resist layer 14 of the silicon wafer 10 on which the carbon nanotube structure 12 and the resist layer 14 were formed was exposed to light at a light quantity of 12.7 mW/cm² for 8 seconds by using a mask aligner (mercury vapor lamp manufactured by Mikasa, MA-20, wavelength of 436 nm).

Furthermore, the exposed silicon wafer 12 was heated on a hot plate at 110°C for 1 minute. Then, the silicon wafer was left to stand to cool, and development was performed on a developing machine (AD-1200, Takizawa Industries) by using as a developer NMD-3 available from TOKYO OHKA KOGYO CO., LTD (tetramethyl ammonium hydroxide 2.38 mass%) (Fig. 2(c)).

### (C-2) Removing Step

The silicon wafer 12 on which the resist layer 14 was thus formed into the shape of the predetermined pattern was heated in a mixed gas (oxygen 10 mL/min, nitrogen 40 mL/min) at 200°C and irradiated with ultraviolet rays (172 nm) for 2 hours by using a UV usher (excimer vacuum ultraviolet lamp, manufactured by Atom Giken, EXM-2100BM, wavelength of 172 nm) to generate oxygen radicals, thereby removing a portion of the carbon nanotube structure 12 which was not protected by the resist layer 14. As a result, the carbon nanotube structure 12 was formed into the shape of the carrier transporter in a state of being covered with the resist layer 14 (Fig. 2(d)).

The resist layer 14 remains on the surface of the base body 10 through the carbon nanotube structure 12.

### (C-3) Resist Layer Peeling-off Step

The resist layer 14 remaining as an upper layer of the carbon nanotube structure 12 formed into the shape of the "predetermined pattern" was removed by washing it with acetone (Fig. 2 (e)) to obtain a carrier transporter of Example 1.

Aluminum and titanium electrodes were formed by means of deposition on the transporting layer (carrier transporter) composed of the carbon nanotube structure 12. The resultant was left standing in a dark room to form an aluminum natural oxide film at an interface between the carbon nanotube structure 12 and the aluminum electrode 18, thereby obtaining a device (Fig. 2(f)).

### [Example 2]

A device using a cross-linked film of multi-wall carbon nanotubes as a carrier transporter was prepared according to the same method as that described in Example 1. An aluminum natural oxide film was formed as an oxide film at an interface between an aluminum electrode and a carbon nanotube structure in the same manner as in Example 1. Titanium was used as a material for the other electrode. A method of forming a coat is shown below. The other steps were the same as those of Example 1.

### (A) Supplying Step

### (A-1) Preparation of Cross-linking Solution (Addition Step)

### (i) Addition of Carboxyl Group ... Synthesis of Carbon Nanotube Carboxylic Acid

30 mg of multi-wall carbon nanotube powder (purity: 90%, average diameter: 30 nm, average length: 3 µm, available from Science Laboratories, Inc.) were added to 20 ml of concentrated nitric acid (60 mass% aqueous solution, available from Kanto Kagaku) for reflux at 120°C for 20 hours, to synthesize a carbon nanotube carboxylic acid.

The temperature of the solution was returned to room temperature, and the solution was centrifuged at 5,000 rpm for 15 minutes to separate a supernatant solution from a precipitate. The recovered precipitate was dispersed in 10 ml of pure water, and the dispersion solution was centrifuged again at 5,000 rpm for 15 minutes to separate a supernatant solution from a precipitate (the above process constitutes one washing operation). This washing operation was repeated five more times, and finally, a precipitate was recovered.

An infrared absorption spectrum of the recovered precipitate wasmeasured. An infrared absorption spectrum of the used multi-wall carbon nanotube raw material itself was also measured for comparison. A comparison between both the spectra revealed that absorption at 1, 735 cm⁻¹ characteristic of a carboxylic acid, which was not observed in the multi-wall carbon nanotube raw material itself, was observed in the precipitate. This finding shows that a carboxyl group was introduced into a carbon nanotube by the reaction with nitric acid. In other words, this finding confirmed that the precipitate was a carbon nanotube carboxylic acid.

Addition of the recovered precipitate to neutral pure water confirmed that dispersability was good. This result supports the result of the infrared absorption spectrum that a hydrophilic carboxyl group was introduced into a carbon nanotube.

### (Mixing Step)

30 mg of the carbon nanotube carboxylic acid methyl esterified in the above step were added to 4 g of glycerin (available from Kanto Kagaku), and the whole was mixed using an ultrasonic disperser. Further, the mixture was added to 4 g of methanol as a viscosity modifier to prepare a cross-linking solution (1).

### [Example 3]

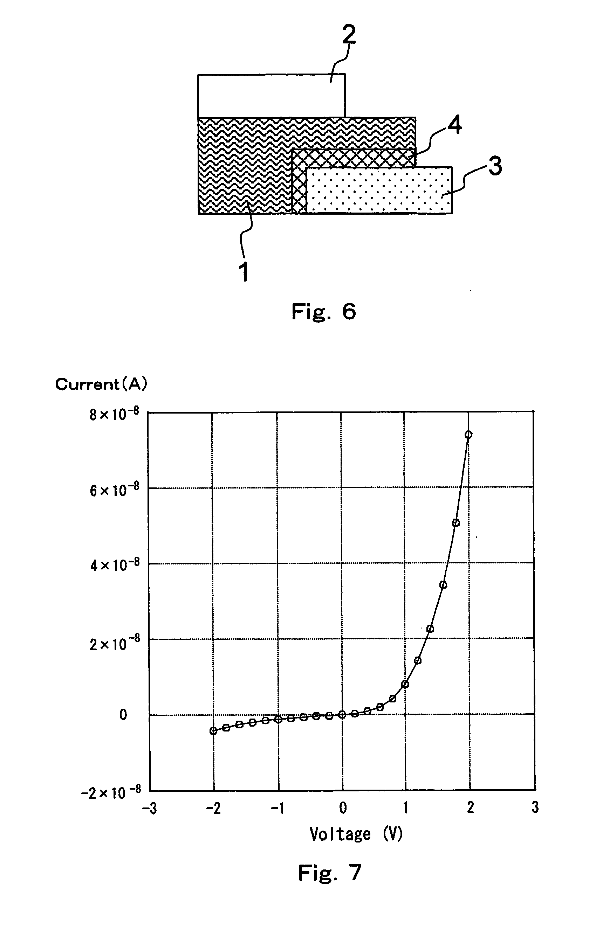

In this example, as shown in Fig. 6, a rectifying device having a sandwich structure in which a carrier transporter was sandwiched on a substrate was manufactured. Fig. 6 is a sectional diagram of the rectifying device of this example.

An aluminum electrode 3 serving as a main electrode was formed in advance on a silicon wafer (not shown) serving as a substrate. An alumina (Al₂O₃) layer 4 for forming a barrier was laminated by means of deposition on the aluminum electrode 3.

Next, in the same manner as in Example 1, a single-wall carbon nanotube structure 1 serving as a carrier transporting layer was formed. Furthermore, titanium/gold was deposited as an upper electrode 2 to manufacture a rectifying device. The deposited alumina had a thickness of about 70 nm.

### [Evaluation Test (Measurement of Current-Voltage Characteristics)]

Direct current-voltage characteristics of the devices of Examples 1 to 3 were measured.

The measurement was performed according to the two-terminal method by using a Picoammeter 4140B (manufactured by Hewlett-Packard Development Company, L.P.).

The current-voltage characteristics of the device of Example 1 (Fig. 7) confirmed that rectifying action was obtained, with which a negative voltage applied to the aluminum electrode was turned into a forward bias.

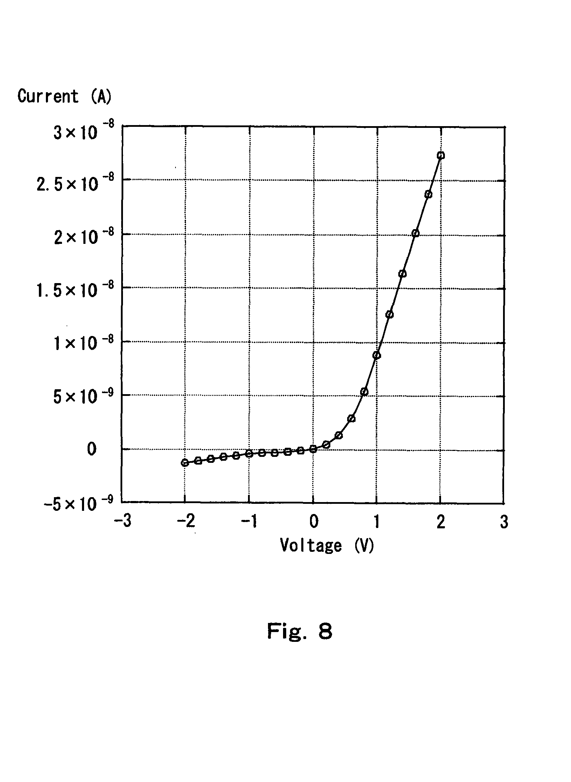

The current-voltage characteristics of the device of Example 2 using a cross-linked film of multi-wall carbon nanotubes (Fig. 8) also confirmed that the device had rectifying action. Accordingly, it was confirmed that the rectifying device of the present invention can express rectifying action irrespective of whether a single-wall carbon nanotube or a multi-wall carbon nanotube is used.

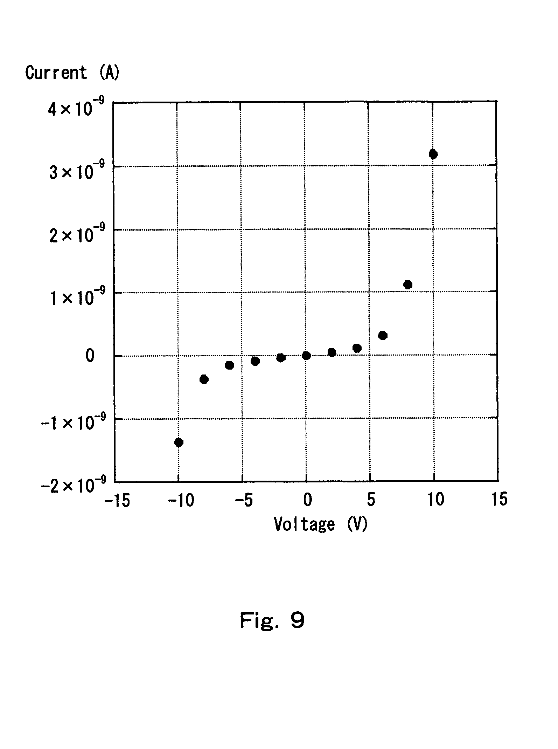

The current-voltage characteristics of the device of Example 3 (Fig. 9) also confirmed that the device had rectifying action. Accordingly, it was confirmed that rectifying action can be expressed by, for example, allowing an oxide film to be present at an interface between a carrier transporter composed of a carbon nanotube structure and one of two electrodes to make a connection configuration different.

## Claims

1. A rectifying device, comprising:
a pair of electrodes; and
a carrier transporter arranged between the pair of electrodes and composed of one or multiple carbon nanotubes, **characterized in that** a first connection configuration between one electrode of the pair of electrodes and the carrier transporter and a second connection configuration between the other electrode of the pair of electrodes and the carrier transporter are made different from each other in such a manner that a first interface between the one electrode and the carrier transporter and a second interface between the other electrode and the carrier transporter have different barrier levels.

2. A rectifying device according to claim 1, **characterized in that** the carrier transporter is composed of multiple carbon nanotubes.

3. A rectifying device according to claim 2, **characterized in that** the carrier transporter is formed by a carbon nanotube structure having a network structure in which the multiple carbon nanotubes mutually cross-link.

4. A rectifying device according to claim 1, **characterized in that** an oxide layer is allowed to be present on at least one of the first interface and the second interface in such a manner that the first interface and the second interface have different barrier levels.

5. A rectifying device according to claim 4, **characterized in that** the oxide layer comprises a metal oxide film or an oxide film of a semiconductor.

6. A rectifying device according to claim 4, **characterized in that** the oxide layer comprises a metal oxide film, and the metal oxide film is composed of an oxide of a material composing the one electrode.

7. A rectifying device according to claim 6, **characterized in that** the pair of electrodes is composed of different materials.

8. A rectifying device according to claim 7, **characterized in that** a material composing one electrode of the pair of electrodes comprises at least one metal selected from the group consisting of titanium, aluminum, silver, copper, silicon that is made conductive, iron, tantalum, niobium, zinc, tungsten, tin, nickel, magnesium, indium, chromium, palladium, molybdenum, and cobalt, or an alloy thereof.

9. A rectifying device according to claim 4, **characterized in that** the oxide layer is composed of at least one selected from the group consisting of aluminum oxide, silicon dioxide, copper oxide, silver oxide, titanium oxide, zinc oxide, tin oxide, nickel oxide, magnesium oxide, indium oxide, chromium oxide, lead oxide, manganese oxide, iron oxide, palladium oxide, tantalum oxide, tungsten oxide, molybdenum oxide, vanadium oxide, cobalt oxide, hafnium oxide, and lanthanum oxide.

10. A rectifying device according to claim 7, **characterized in that** the one electrode is composed of a material having an ionization tendency higher than that of the other electrode.

11. A rectifying device according to claim 1, **characterized in that** a material for the one electrode and a material for the other electrode are made different in such a manner that the first interface and the second interface have different barrier levels.

12. A rectifying device according to claim 11, **characterized in that** the materials composing the one electrode and the other electrode each independently comprise at least one metal selected from the group consisting of aluminum, silver, copper, silicon that is made conductive, gold, platinum, titanium, zinc, nickel, tin, magnesium, indium, chromium, manganese, iron, lead, palladium, tantalum, tungsten, molybdenum, vanadium, cobalt, hafnium, and lanthanum, or an alloy thereof.

13. A rectifying device according to claim 11, **characterized in that** the material composing the other electrode comprises at least one metal selected from the group consisting of gold, titanium, iron, nickel, tungsten, silicon that is made conductive, chromium, niobium, cobalt, molybdenum, and vanadium, or an alloy thereof.

14. A rectifying device according to claim 11, **characterized in that** a degree of adhesion between the one electrode and the carrier transporter at the first interface is smaller than a degree of adhesion between the other electrode and the carrier transporter at the second interface.

15. A rectifying device according to claim 1, **characterized in that** a surface of the carrier transporter is modified at the first interface or the second interface to generate a difference between a degree of adhesion between the one electrode and the carrier transporter at the first interface and a degree of adhesion between the other electrode and the carrier transporter at the second interface.

16. A rectifying device according to claim 1, **characterized in that** an adhesion force adjusting layer is allowed to be present on at least one of the first interface and the second interface to generate a difference between a degree of adhesion between the one electrode and the carrier transporter at the first interface and a degree of adhesion between the other electrode and the carrier transporter at the second interface.

17. A rectifying device according to claim 3, **characterized in that** the carbon nanotube structure is obtained by chemically bonding functional groups bonded to multiple carbon nanotubes to form cross-linked sites.

18. A rectifying device according to claim 17, **characterized in that** the multiple carbon nanotubes mainly comprise single-wall carbon nanotubes.

19. A rectifying device according to claim 17, **characterized in that** the multiple carbon nanotubes mainly comprise multi-wall carbon nanotubes.

20. A rectifying device according to claim 17, **characterized in that** the cross-linked sites each comprise a chemical structure selected from the group consisting of (-COO(CH₂)₂OCO-), -COOCH₂CHOHCH₂OCO-, -COOCH₂CH(OCO-)CH₂OH, -COOCH₂CH(OCO-)CH₂OCO-, and -COO-C₆H₄-COO-.

21. A rectifying device according to claim 3, **characterized in that** the cross-linked sites each comprise a chemical structure selected from the group consisting of -COOCO-, -O-, -NHCO-, -COO-, -NCH-, -NH-, -S-, -O-, -NHCOO-, and -S-S-.

22. A rectifying device according to claim 17, **characterized in that** a solution containing multiple carbon nanotubes to which functional groups are bonded to form the cross-linked sites by chemically bonding the functional groups of the multiple carbon nanotubes.

23. A rectifying device according to claim 17, **characterized in that** a solution containing multiple carbon nanotubes to which functional groups are bonded and a cross-linking agent capable of prompting a cross-linking reaction with the functional groups is cured to subject the functional groups and the cross-linking agent to a cross-linking reaction, to thereby form the cross-linked sites.

24. A rectifying device according to claim 23, **characterized in that** the cross-linking agent comprises a non-self-polymerizable cross-linking agent.

25. A rectifying device according to claim 17, **characterized in that** the cross-linked sites have structures formed by chemical bonding of the functional groups.

26. A rectifying device according to claim 25, **characterized in that** a reaction that forms the chemical bonding comprises a reaction selected from the group consisting of dehydration condensation, a substitution reaction, an addition reaction, and an oxidative reaction.

27. A rectifying device according to claim 2, **characterized in that** the carrier transporter is laminar, and the carbon nanotube structure is patterned into a predetermined shape.

28. A rectifying device according to claim 27, **characterized in that**:
the barrier level at the first interface is higher than the barrier level at the second interface; and
a width of a surface of the one electrode is equal to or greater than a width of the carrier transporter at an interface between the one electrode and the carrier transporter.

29. A rectifying device according to claim 28, **characterized in that** the first connection configuration is obtained by allowing an oxide layer to be present at the first interface.

30. A rectifying device according to claim 1, **characterized by** further comprising a sealing member for sealing at least the first interface against external air.

31. An electronic circuit, **characterized by** comprising:
the rectifying device according to claim 1; and
a flexible base body having the rectifying device formed on its surface.

32. A method of manufacturing a rectifying device including: a base body; a pair of electrodes arranged on a surface of the base body; and a carrier transporter arranged between the pair of electrodes and composed of one or multiple carbon nanotubes, **characterized by** comprising a connection configuration forming step of forming a first connection configuration between one electrode of the pair of electrodes and the carrier transporter and a second connection configuration between the other electrode of the pair of electrodes and the carrier transporter into different configurations in such a manner that a first interface between the one electrode and the carrier transporter and a second interface between the other electrode and the carrier transporter have different barrier levels.

33. A method of manufacturing a rectifying device according to claim 32, **characterized in that** the connection configuration forming step includes an oxide layer forming step of forming, at the first interface between the one electrode and the carrier transporter, an oxide layer such that the first interface has a barrier level different from that of the second interface between the other electrode and the carrier transporter.

34. A method of manufacturing a rectifying device according to claim 33, **characterized in that** the oxide layer forming step comprises a step including: arranging an oxide precursor layer composed of a material that can be oxidized at the first interface; and oxidizing the oxide precursor layer.

35. A method of manufacturing a rectifying device according to claim 34, **characterized in that**:
the carrier transporter is formed by a carbon nanotube structure having a network structure in which multiple carbon nanotubes mutually cross-link; and
the oxide layer forming step comprises a step including: forming the oxide precursor layer so as to be in contact with the carrier transporter; and oxidizing the oxide precursor layer.

36. A method of manufacturing a rectifying device according to claim 33, **characterized in that** the oxide layer forming step comprises a step including: forming one electrode of the pair of electrodes from a material that can be oxidized; and oxidizing a surface of the one electrode at the first interface to form an oxide layer.

37. A method of manufacturing a rectifying device according to claim 36, **characterized in that**:
the carrier transporter is formed by a carbon nanotube structure having a network structure in which multiple carbon nanotubes mutually cross-link; and
the oxide layer forming step comprises a step including: forming the one electrode so as to be in contact with the carrier transporter; and oxidizing the one electrode at a surface where the electrode and the carrier transporter are in contact with each other.

38. A method of manufacturing a rectifying device according to claim 36, **characterized in that** a material composing one electrode of the pair of electrodes comprises at least one metal selected from the group consisting of aluminum, silver, copper, silicon that is made conductive, titanium, zinc, nickel, tin, magnesium, indium, chromium, manganese, iron, lead, palladium, tantalum, tungsten, molybdenum, vanadium, cobalt, hafnium, and lanthanum, or an alloy thereof.

39. A method of manufacturing a rectifying device according to claim 33, **characterized in that** the other electrode is composed of a material having an ionization tendency lower than that of the one electrode.

40. A method of manufacturing a rectifying device according to claim 33, **characterized in that** a material composing the other electrode comprises at least one metal selected from the group consisting of gold, titanium, iron, nickel, tungsten, silicon that is made conductive, chromium, niobium, cobalt, molybdenum, and vanadium, or an alloy thereof.

41. A method of manufacturing a rectifying device according to claim 32, **characterized in that** the connection configuration forming step includes a step of forming the pair of electrodes from different materials.

42. A method of manufacturing a rectifying device according to claim 32, **characterized in that** the connection configuration forming step includes a step of modifying a surface of the carrier transporter at the first interface or the second interface to generate a difference between a degree of adhesion between the one electrode and the carrier transporter at the first interface and a degree of adhesion between the other electrode and the carrier transporter at the second interface.

43. A method of manufacturing a rectifying device according to claim 32, **characterized in that** the connection configuration forming step includes a step of forming an adhesion force adjusting layer on at least one of the first interface and the second interface to generate a difference between a degree of adhesion between the one electrode and the carrier transporter at the first interface and a degree of adhesion between the other electrode and the carrier transporter at the second interface.

44. A method of manufacturing a rectifying device according to claim 32, **characterized in that** the carrier transporter is formed by a network structure in which multiple carbon nanotubes which are not chemically bonded together are entangled.

45. A method of manufacturing a rectifying device according to claim 32, **characterized in that** the carrier transporter is composed of a carbon nanotube structure having a network structure in which the multiple carbon nanotubes mutually cross-link.

46. A method of manufacturing a rectifying device according to claim 32, further comprising, prior to the connection formation forming step, a carrier transporter forming step of forming the carrier transporter, **characterized in that** the carrier transporter forming step includes:
a supplying step of supplying the surface of the base body with multiple carbon nanotubes having functional groups; and
a cross-linking step of cross-linking the functional groups via cross-linked sites to form the carbon nanotube structure having the network structure.

47. A method of manufacturing a rectifying device according to claim 46, **characterized in that**:
the supplying step includes an applying step of applying a solution containing the carbon nanotubes having the functional groups to the surface of the base body; and
the carbon nanotube structure is filmy.

48. A method of manufacturing a rectifying device according to claim 46, **characterized in that** the multiple carbon nanotubes mainly comprise single-wall carbon nanotubes.

49. A method of manufacturing a rectifying device according to claim 46, **characterized in that** the multiple carbon nanotubes mainly comprise multi-wall carbon nanotubes.

50. A method of manufacturing a rectifying device according to claim 46, **characterized in that** the supplying step includes supplying a cross-linking agent for cross-linking the functional groups to the surface of the base body.

51. A method of manufacturing a rectifying device according to claim 50, **characterized in that** the cross-linking agent comprises a non-self-polymerizable cross-linking agent.

52. A method of manufacturing a rectifying device according to claim 46, **characterized in that**:
the functional groups comprise at least one functional group selected from the group consisting of -OH, -COOH, -COOR (where R represents a substituted or unsubstituted hydrocarbon group), -COX (where X represents a halogen atom), -NH₂, and -NCO; and
the cross-linking agent is capable of prompting a cross-linking reaction with the selected functional group.

53. A method of manufacturing a rectifying device according to claim 50, **characterized in that**:
the cross-linking agent comprises at least one cross-linking agent selected from the group consisting of a polyol, a polyamine, a polycarboxylic acid, a polycarboxylate, a polycarboxylic acid halide, a polycarbodiimide, and a polyisocyanate; and
each of the functional groups is capable of prompting a cross-linking reaction with the selected cross-linking agent.

54. A method of manufacturing a rectifying device according to claim 50, **characterized in that**:
the functional groups comprise at least one functional group selected from the group consisting of -OH, -COOH, -COOR (where R represents a substituted or unsubstituted hydrocarbon group), -COX (where X represents a halogen atom), -NH₂, and -NCO;
the cross-linking agent comprises at least one cross-linking agent selected from the group consisting of a polyol, a polyamine, a polycarboxylic acid, a polycarboxylate, a polycarboxylic acid halide, a polycarbodiimide, and a polyisocyanate; and
a combination of the selected functional group and the selected cross-linking agent is capable of prompting a mutual cross-linking reaction.

55. A method of manufacturing a rectifying device according to claim 46, **characterized in that** each of the functional groups comprises-COOR (where R represents a substituted or unsubstituted hydrocarbon group).

56. A method of manufacturing a rectifying device according to claim 55, **characterized in that** the cross-linking agent comprises a polyol.

57. A method of manufacturing a rectifying device according to claim 56, **characterized in that** the cross-linking agent comprises at least one selected from the group consisting of glycerin, ethylene glycol, butenediol, hexynediol, hydroquinone, andnaphthalenediol.

58. A method of manufacturing a rectifying device according to claim 46, **characterized in that** a reaction for cross-linking the functional groups in the cross-linking step comprises a reaction for chemically bonding the functional groups.

59. A method of manufacturing a rectifying device according to claim 58, **characterized in that** the supplying step includes supplying an additive that forms the chemical bonding of the functional groups to the surface of the base body.

60. A method of manufacturing a rectifying device according to claim 59, **characterized in that** the reaction comprises dehydration condensation and the additive comprises a condensation agent.

61. A method of manufacturing a rectifying device according to claim 60, **characterized in that** the functional groups comprise at least one functional group selected from the group consisting of -COOR (where R represents a substituted or unsubstituted hydrocarbon group), -COOH, -COX (where X represents a halogen atom), -OH, -CHO, and -NH₂.

62. A method of manufacturing a rectifying device according to claim 60, **characterized in that** each of the functional groups comprises -COOH.

63. A method of manufacturing a rectifying device according to claim 60, **characterized in that** the condensation agent comprises one selected from the group consisting of sulfuric acid, N-ethyl-N'-(3-dimethylaminopropyl)carbodiimide, and dicyclohexyl carbodiimide.

64. A method of manufacturing a rectifying device according to claim 59, wherein the reaction comprises a substitution reaction and the additive comprises a base.

65. A method of manufacturing a rectifying device according to claim 64, wherein the functional groups comprise at least one functional group selected from the group consisting of-NH₂, -X (where X represents a halogen atom), -SH, -OH, -OSO₂CH₃, and -OSO₂(C₆H₄) CH₃.

66. A method of manufacturing a rectifying device according to claim 64, **characterized in that** the base comprises one selected from the group consisting of sodium hydroxide, potassium hydroxide, pyridine, and sodium ethoxide.

67. A method of manufacturing a rectifying device according to claim 58, **characterized in that** the reaction comprises an addition reaction.

68. A method of manufacturing a rectifying device according to claim 67, **characterized in that** the functional groups comprise at least one chosen from -OH and -NCO.

69. A method of manufacturing a rectifying device according to claim 59, **characterized in that** the reaction comprises an oxidative reaction.

70. A method of manufacturing a rectifying device according to claim 69, **characterized in that** each of the functional groups comprises -SH.

71. A method of manufacturing a rectifying device according to claim 69, **characterized in that** the additive comprises an oxidative reaction accelerator.

72. A method of manufacturing a rectifying device according to claim 71, **characterized in that** the oxidative reaction accelerator comprises iodine.

73. A method of manufacturing a rectifying device according to claim 32, **characterized in that**:
the carrier transporter is formed by a carbon nanotube structure having a network structure in which the multiple carbon nanotubes mutually cross-link; and
the method further comprises a patterning step of patterning the carbon nanotube structure into a pattern corresponding to the carrier transporter.

74. A method of manufacturing a rectifying device according to claim 73, **characterized in that** the patterning step comprises a step in which the carbon nanotube structure in a region on the surface of the base body other than a pattern corresponding to the carrier transporter is subjected to dry etching to remove the carbon nanotube structure in the region, whereby the carbon nanotube structure is patterned into a pattern corresponding to the carrier transporter.

75. A method of manufacturing a rectifying device according to claim 74, **characterized in that** the patterning step includes:
a resist layer forming step of forming a resist layer above the carbon nanotube structure in a region on the surface of the base body having the pattern corresponding to the carrier transporter; and
a removing step of removing the carbon nanotube structure exposed in a region other than the region by subjecting a surface of the base body on which the carbon nanotube structure and the resist layer are laminated to dry etching.

76. A method of manufacturing a rectifying device according to claim 75, **characterized in that**, in the removing step, the surface of the base body on which the carbon nanotube structure and the resist layer are laminated is irradiated with an oxygen molecule radical.

77. A method of manufacturing a rectifying device according to claim 76, **characterized in that** oxygen molecules are irradiated with ultraviolet rays to generate an oxygen molecule radical, which is used as a radical with which the surface of the base body on which the carbon nanotube structure and the resist layer are laminated is irradiated.

78. A method of manufacturing a rectifying device according to claim 75, **characterized in that** the patterning step further includes a resist layer peeling-off step of peeling off the resist layer formed in the resist layer forming step subsequent to the removing step.

79. A method of manufacturing a rectifying device according to claim 75, **characterized in that** the resist layer comprises a resin layer.

80. A method of manufacturing a rectifying device according to claim 74, **characterized in that** the patterning step comprises a step of patterning the carbon nanotube structure into the pattern corresponding to the carrier transporter by selectively irradiating the carbon nanotube structure in a region of the surface of the base body other than the region having the pattern corresponding to the carrier transporter with an ion beam of a gas molecule to remove the carbon nanotube structure in the region.
